# EUROPEAN PATENT SPECIFICATION

(11) **EP 3 706 920 B1**
(45) Date of publication and mention of the grant of the patent: **29.04.2026**
(21) Application number: 18811416.9
(22) Date of filing: 02.11.2018
(51) Int. Cl.: B05C 11/10, B05C 5/02, H05K 3/00

(54) **SYSTEMS AND METHODS FOR ENHANCED COATING DISPENSING CONTROLS**
SYSTEME UND VERFAHREN FÜR VERBESSERTE BESCHICHTUNGSAUSGABEKONTROLLE
SYSTÈMES ET PROCÉDÉS POUR DES COMMANDES AMÉLIORÉES DE DISTRIBUTION D'UN REVÊTEMENT

(30) Priority: 10.11.2017 US 201762584622 P
(43) Date of publication of application: 16.09.2020
(73) Proprietor: Nordson Corporation, Westlake, OH 44145-1119 (US)
(72) Inventor: VAN DE VIJVER, Michel, 3070 Kortenbert (BE); ETIENNE, Stephane, 44830 Bouaye (FR); FRANKEN, Ronny, 3650 Dilsen-stokkem (BE); KNIPPENBERG, Marc, 3960 Bree (BE)
(74) Representative: Reddie & Grose LLP
(86) International application number: PCT/US2018/058877
(87) International publication number: WO 2019/094282

(56) References cited:
- EP-A1- 2 202 005
- EP-A1- 2 248 600
- WO-A1-2010/006141
- WO-A1-2017/079366
- US-A1- 2010 108 256
- US-B1- 9 789 497

## Description

### TECHNICAL FIELD

This disclosure generally relates to liquid applications and, more particularly, systems and methods for enhanced coating dispensing controls.

### BACKGROUND

Precision, accuracy, and consistency are important aspects in most any industrial process. This is especially true in many dispensing applications, such as those systems that apply conformal coating or other fluid to a substrate. Conformal coating typically refers to the process of applying a fluid to select areas of a substrate, such as a printed circuit board (PCB). Various intricate components of inconsistent shape and arrangement are typically affixed to the surface of a PCB or other such substrate. The conformal coating process must navigate the irregularities of the substrate and apply fluid at particular locations, at specific degrees of thickness, and other similar characteristics. Due to the complex and delicate nature of a PCB or other subject substrate, it is evident that the coating process must be performed within strict tolerances over many iterations. Other types of dispensing systems, such as jetting systems, that apply fluid to various types of substrates are similarly demanding.

A system and method for dispensing adhesive dots onto a plurality of disk drives is known from US 2010/108256. Other examples of dispensing systems are known from EP 2202005, WO 2017/079366, EP 2248600, and US 9789497. Further examples of systems and methods for applying a liquid coating to a substrate are known from US 978497 B1 and WO 2010/006141 A1.

Many current systems, however, experience difficulty in maintaining such a high standard of precision and accuracy. These and other shortcomings are addressed in the present disclosure.

### SUMMARY

Disclosed herein are systems and methods for enhanced coating dispensing controls. In one example method, a dispensing system is operated by a controller and has a dispensing device configured to apply material to a sequence of substrates. Initially, the dispensing system applies a first amount of material to a first substrate of the sequence of substrates according to a first value of an operating parameter of the dispensing system. A sensor is used to measure a characteristic of the first amount of material applied on the first substrate. Based on the characteristic of the first amount of material applied on the first substrate, it is determined that a characteristic of an amount of material, after being applied on a subsequent substrate in the sequence of substrates, is estimated to be outside of a range. The value of the operating parameter is adjusted in response and a second amount of liquid is applied to a second substrate of the sequence of substrates. The characteristic of the first amount of material applied on the first substrate is different than a characteristic of the second amount of material applied on the second substrate.

An example dispensing system includes dispensing device and a sensor that is arranged to measure a characteristic of an amount of material applied by the dispensing device to a substrate of a sequence of substrates. The system further comprises a controller configured to generate one or more signals to effectuate the following steps. The dispensing device is operated to apply a first amount of material on a first substrate of the sequence of substrates according to a first value of an operating parameter of the dispensing system. Information is generated, using the sensor, concerning a characteristic of the first amount of material applied on the first substrate. Based on the information concerning the characteristic of the first amount of material, an estimate is determined in which the estimate is a characteristic of an amount of material, after being applied on a subsequent substrate in the sequence of substrates. The estimate of the characteristic of the amount of material, after being applied on the subsequent substrate, is compared with a range to determine that the estimate of the characteristic is outside of the range. The value of the operating parameter is adjusted to a second value in response to determining that the estimate of the characteristic of the amount of material, after being applied on the subsequent substrate, is outside of the range. According to the second value of the operating parameter, a second amount of material from the dispensing device is applied to a second substrate of the sequence of substrates, wherein the characteristic of the first amount of material applied on the first substrate is different than a characteristic of the second amount of material applied on the second substrate.

According to the present invention there is provided a method for controlling a dispensing system operated by a controller and having a dispensing device configured to apply a liquid or viscous material to a sequence of substrates that are moved through the dispensing system, as set out in the accompanying claims. The present invention further provides a dispensing system for applying a liquid or viscous material to substrates that are moved through the dispensing system configured to implement such a method, as set out in the accompanying claims.

### BRIEF DESCRIPTION OF DRAWINGS

The accompanying drawings, which are incorporated in and constitute a part of this specification, illustrate embodiments and together with the description, serve to explain the principles of the methods and systems:
FIG. 1 illustrates a side view of a coating system according to an embodiment of the present disclosure;
FIG. 2A illustrates a coating assembly according to an embodiment of the present disclosure;
FIG. 2B illustrates a schematic diagram of an alternative coating system according to an embodiment of the present disclosure;
FIG. 3A illustrates portions of an inspection station according to an embodiment of the present disclosure;
FIG. 3B illustrates portions of an inspection station according to an embodiment of the present disclosure;
FIG. 4 illustrates a data flow diagram according to an embodiment of the present disclosure; and
FIG. 5 illustrates a method flow chart according to an embodiment of the present disclosure.

Aspects of the disclosure will now be described in detail with reference to the drawings, wherein like reference numbers refer to like elements throughout, unless specified otherwise.

### DETAILED DESCRIPTION

The systems and methods of the present disclosure relate to enhanced controls in coating dispensing processes. The enhanced controls are implemented in a system having a dispenser that applies a fluid to a substrate, an inspection station to measure one or more values of various characteristics of the applied fluid, and/or a curing oven to cure the coated substrate.

The dispenser and/or other components of the system operate according to one or more operating parameters that affect various characteristics of the applied fluid. One example operating parameter may be the fluid pressure of the fluid as it is supplied to the dispenser. As noted, the substrate coated according to those operating parameters may be inspected, such as via a camera, to determine the value of one or more of the coating characteristic values. Based on that value, and/or a store of similar past values, a prediction is made as to the future value of that coating characteristic for a later substrate. If the predicted value is unacceptable or represents a trend towards an unacceptable value, the operating parameter value may be adjusted for the subsequent substrates. For example, the fluid pressure of the fluid may be reduced or raised, as the case may be. Preferably, the system preemptively avoids errors or faults caused by the various coating characteristic values of the fluid exceeding set tolerance ranges.

The disclosed systems and methods may also find use in verifying the capability of the dispensing portion (e.g., the dispenser) of the system at large, including any processes performed by the dispensing portion of the system. For example, the disclosed systems and methods may be used in determining a process capability index or process capability ratio, such as Cₚₖ.

The teachings disclosed herein may be applied with a wide variety of material dispensing system types, including those with variations in mode of dispensing operation, mechanical configuration, valve type, substrate, and/or material. Thus, teachings made with reference to coating, dispensing, applying, jetting, needle (or similar forms of descriptor), or any other characterization of apparatus type, valve type, and/or operation may apply equally to all other types of apparatus, valves, and/or operations. This is, of course, unless clearly indicated otherwise by express statement or context. Similarly, any teaching made with reference to a type or characterization of material (e.g., coating, fluid, liquid, viscous material, and/or combination thereof) may apply equally to all other materials, unless clearly indicated otherwise either expressly or by context. The same holds true for any teachings made with reference to a particular type of substrate, such as a printed circuit board (PCB). Thus, a teaching made with reference to a PCB applies equally to other types of substrates. Likewise, a teaching made with reference to simply a substrate may also apply to any form of substrate, including a PCB. Again, a clear express statement or an unambiguous context may indicate that a teaching applies only to a particular type of substrate.

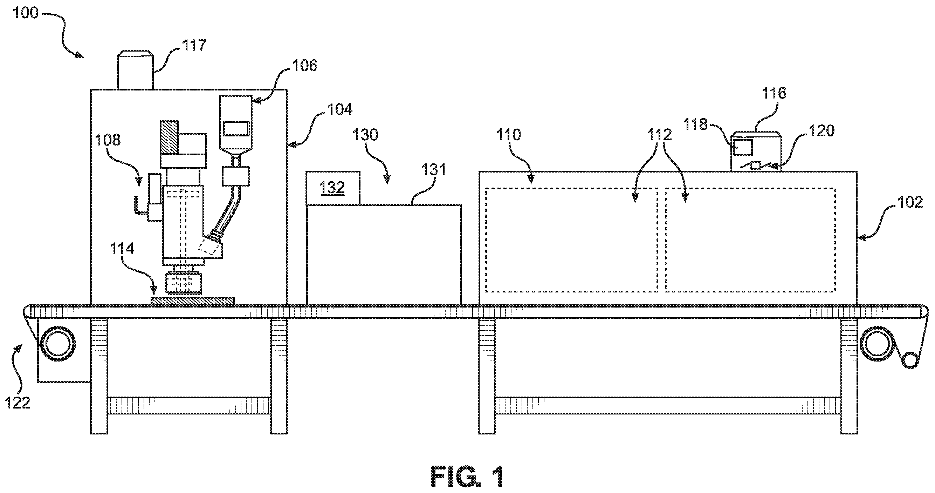

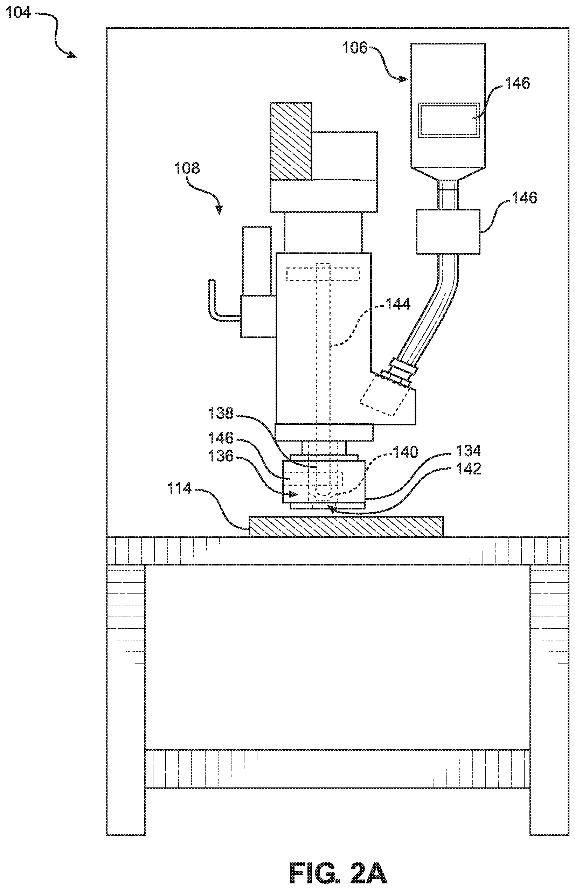

With reference to FIGS. 1 and 2A, a system 100 for applying a fluid (e.g., a coating material, a viscous material, or other type of material) to a series of sequential substrates includes a coating assembly 104, an inspection station 130, and a curing oven 102. The coating assembly 104 selectively applies the fluid to a substrate 114. The coated substrate 114 is then transferred to the inspection station 130 via a conveyor 122 or other form of transport. The inspection station 130 includes one or more sensors that measure the value(s) of one or more characteristics of the fluid on the substrate 114. The data collected by the inspection station 130 is received and processed by a controller 132. Based on the measured value of the coating characteristic, the controller 132 determines or estimates whether future coating applications performed under the same or similar operating parameters will, or are likely to, yield a substrate coating with one or more characteristic values that are outside of a pre-determined tolerance range of values or other quality metric. If so indicated, the controller 132 alters one or more operating parameters of the coating assembly 104 or other component of the system 100 to prevent the value of the corresponding coating characteristic in subsequent coated substrates from falling outside the tolerance range. Following inspection, the coated substrate 114 may be transferred to the oven 102 for the coating to be cured.

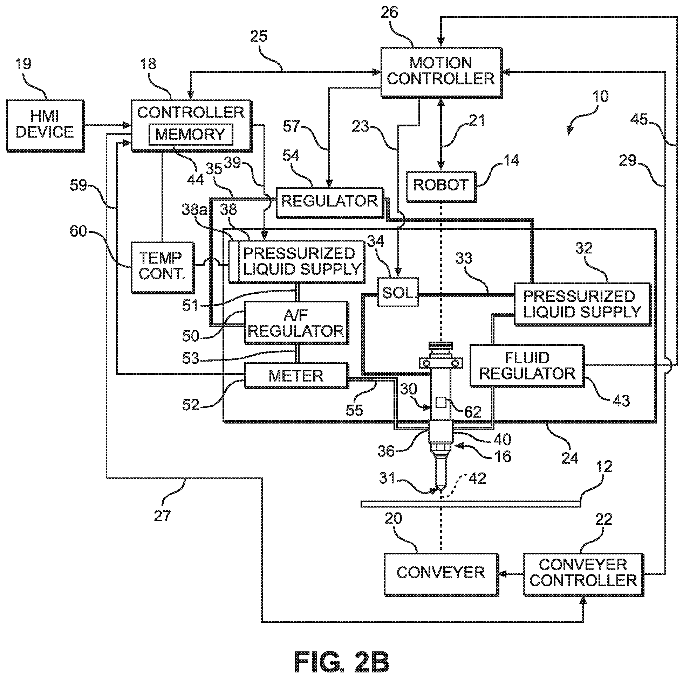

With particular attention to FIG. 2A, the coating assembly 104 includes a coating dispenser 108 for selectively applying the fluid to the substrate 114. It is noted that the particular coating assembly 104 and dispenser 108 described and shown herein are merely exemplary and the disclosure is not so limited. Rather, the dispenser 108 may be realized in one of various forms, some of which may operate according to differing dispensing mechanisms or principles of operation. For example, the dispenser 108 may be realized in a form that is configured to apply fluid as droplets or beads, a monofilament (e.g., a straight line or a looping line), a swirl or spray pattern/area, or any combination thereof. As another example, the dispenser 108 may be configured with one or more air jets (not shown) to atomize or otherwise impinge the fluid as it exits the nozzle of the dispenser 108. Conversely, the dispenser 108 may be configured without any air jets and dispenses the fluid without atomization or other effects caused by an air stream. FIG. 2B, discussed below, illustrates an example alternative coating system.

The dispenser 108 is supplied fluid by a fluid source 106. The dispenser 108 is equipped with a nozzle 134 that operates to dispense a volume of fluid to the substrate 114. In particular, the nozzle 134 comprising a valve 136 that may be opened and closed to dispense the fluid. As pictured, the valve 136 may be opened and closed to dispense fluid by action of a drive pin 138 moving towards a valve seat 140 within the nozzle 134. As the drive pin 138 moves towards the valve seat 140, the intervening fluid is dispensed from an opening 142 at the tip of the nozzle 134. The drive pin 138 is driven by an actuator 144, such as a pneumatic actuator or piezoelectric actuator. The actuator 144 may be mechanically coupled to the drive pin 138 or may periodically decouple from the drive pin 138 while in operation. Additionally or alternatively to the aforementioned arrangement of the valve seat 140, the drive pin 138, and the actuator 144, the fluid may be motivated by fluid pressure (e.g., from the fluid source 106) to cause the fluid to be dispensed from the nozzle 134. For example, when the valve 136 is opened, the fluid may be expelled from the opening 142. The operations of the various components of the dispenser 108 and parameters thereof may be governed and controlled by the controller 132.

The coating assembly 104 may be configured with one or more flow meters 146 that may each be configured to measure the flow rate, velocity and/or fluid pressure of the fluid flowing through the associated structure. For example, a flow meter 146 may be integrated with or positioned in associated with the fluid source 106, the passage (not labeled) leading from the fluid source 106 to the dispenser 108, and/or the nozzle 134 of the dispenser 108. The data measured by the flow meters 146 may be communicated to the controller 132, which may use this data to determine if a tolerance range is likely to be exceeded and to determine which operating parameter is to be adjusted and to what degree.

The coating assembly 104 may be configured to afford the dispenser 108 with freedom of movement over three dimensions, such as the X, Y, and Z coordinates, with the frame of reference being the planar surface of the substrate 114 or the surface upon which the substrate 114 rests. In some instances, the dispenser 108 may be configured to tilt the nozzle 134 with respect to the nozzle's 134 vertical axis (i.e., the axis of the nozzle 134 that is parallel to the Z axis when the nozzle 134 is at rest). The surface supporting the substrate 114 may be configured to move in relation to the dispenser 108 in addition to or as an alternative to the dispenser 108 moving in relation to the substrate 114.

FIG. 2B illustrates a coating system 10 that may be used with the system 100 in addition to, in full or in part, or as alternative to, in full or in part, the coating assembly 104 shown in FIG. 2A. The coating system 10 may be used to apply a liquid coating material, such as a conformal coating material, to a series of substrates, such as the representative substrate 12. Although the operation of a representative coating system 10 will be described herein, those skilled in the art will appreciate that a wide variety of other coating systems may be used to complete the method described below. The coating system 10 may be, for example, a Model SC-105, SC-205, or SC-400 conformal coating applicator commercially available from Asymtek (Carlsbad, Calif.).

In the representative embodiment, the coating system 10 includes a multi-axis electro-mechanical positioner or robot 14 and a conformal coating applicator 16 coupled with the robot 14. For example, the applicator 16 may be suspended from the robot 14 above the substrates 12. In one embodiment, the robot 14 is adapted to move the applicator 16 in directions defined within an X-Y-Z Cartesian coordinate frame to supply three degrees of freedom. The robot 14 includes a drive coupled to independently controllable motors (not shown) in a known manner. The applicator 16 is manipulated by robot 14 relative to the substrate 12 for applying amounts of liquid coating material to selected areas of the substrate 12.

A programmable controller 18 coordinates the movements and actuations of the coating system 10. The controller 18 may be a programmable logic controller (PLC), a microprocessor based controller, personal computer, or another conventional control device capable of carrying out the functions described herein as understood by a person having ordinary skill in the art. For example, the controller 18 may perform various flow control routines and fan width control routines. A human machine interface (HMI) device 19 is operatively connected to the controller 18 in a known manner. The HMI device 19 may include input devices and controls, such as a keypad, pushbuttons, control knobs, a touch screen, etc., and output devices, such as displays and other visual indicators, that are used by an operator to control the operation of the controller 18 and, thereby, control the operation of the coating system 10. The HMI device 19 may further include an audio output device, such as a speaker, by which an audio alert may be communicated to an operator.

Substrates 12, for example, printed circuit boards with attached semiconductor die and other components, are supported in an operative relationship with the applicator 16 in a known manner and liquid coating material is applied from the applicator 16 onto selected areas on each substrate 12. Depending on the dispensing application, a series of substrates 12 may be coated in a batch mode. Alternatively, the substrates 12 may be continuously transported past the applicator 16 on an automatic conveyor 20. The conveyor 20 has a conventional design and, furthermore, may have a width that can be adjusted to accommodate substrates 12 of different dimensions. The conveyor 20, which may also include pneumatically operated lift and lock mechanisms (not shown), receives command signals from a conveyor controller 22.

The applicator 16 is electrically coupled with an applicator controller 24, which supplies command signals that control the operation of the applicator 16. A motion controller 26 is electrically coupled by a communication link 21 with the robot 14. The solenoid 34 is electrically coupled by a communication link 23 with the motion controller 26. The conveyor controller 22 and motion controller 26 are also electrically coupled with controller 18 over respective communication links 25, 27. The motion controller 26 is electrically coupled over a communication link 29 with the conveyor controller 22. Thus, a programmable control system for coating system 10 includes the controller 18, the applicator controller 24, the motion controller 26, and the optional conveyor controller 22 as interconnected components that communicate with each other.

The motion controller 26 supplies command signals to the robot 14 over the communication link 21. The command signals are used by the robot 14 to control the position and/or velocity of the applicator 16. Generally, the robot 14 includes electric motors, such as servo motors or stepper motors, that drive the motion of the different axes of the robot 14.

Applicator 16 includes a body 30 suspended from the robot 14, a nozzle 31 mounted to one end of the body 30, and a flow control mechanism (not shown) disposed inside the body 30. The flow control mechanism inside body 30 may comprise an air-actuated needle, an air piston, and a valve seat that cooperate to form a dispensing valve (not shown) operative to control a flow of conformal coating material dispensed from the applicator 16. A pressurized fluid supply 32 and a solenoid 34 cooperate to supply pressurized fluid in a known manner to regulate the actuation of the dispensing valve inside the body 30. Specifically, the solenoid 34 controls air pressure in a conduit 33 connecting the pressurized fluid supply 32 with the applicator 16 so as to move the air piston and, thereby, move the needle relative to the valve seat to provide an opened position for the dispensing valve in which liquid coating material is dispensed from the applicator 16 onto the substrate 12. The solenoid 34 may vent the air pressure acting on the air piston to permit the needle to return to a closed position in which the needle contacts the valve seat to discontinue the dispensing.

The coating system 10 may include a fan width sensor 62 that may be disposed, for example, on the robot 14 or the applicator 16. In some aspects, the fan width sensor 62 may also be a separate module independent from the robot 14 and the applicator 16. The fan width sensor 62 may be configured to determine various characteristics (e.g., width or shape) of the fan of the material dispensed from the applicator 16. As used herein, the fan of the material refers to the shape, and dimensions thereof, of the stream 42 of material from the applicator 16. For example, the applicator 16 may dispense the material in a conical spray at a known distance between the applicator 16 and the substrate 12, whereby the conical spray will produce a circular area of coating on the substrate 12 with a certain diameter. As the applicator 16 moves along the substrate 12, the conical spray of the material will produce a strip of coating on the substrate 12 having a width corresponding with the certain diameter of the conical spray. The fan width sensor 62 may be communicatively connected with the motion controller 26 and/or controller 18. For instance, the data points indicative of the fan of material and determined by the fan width sensor 62 may be communicated to the controller 18 and stored in the memory 44 therein.

In an aspect, the fan width sensor 62 may include a camera and a light or laser source, wherein the stream 42 of material may be positioned between the camera and the light or laser source to determine the various characteristics (e.g., width or shape) of the stream 42 of material. The camera may be configured to capture images of the fluid pattern of the stream 42 as it is dispensed from the applicator 16. The images captured by the camera may be still images or images that comprise a video stream. The camera may forward the images of the fluid pattern to the controller 18, which may use the images to perform other processing steps, such as a fan width control routine. The light or laser source may be configured to emit light or a laser through the fluid pattern of the stream 42. For example, the light or laser source may be located directly in front of the camera on the other side of the applicator 16 and on the same horizontal plane as the camera. The light or laser source may provide illumination of the fluid pattern of the stream 42 to improve image quality of the images captured by the camera. The fan width sensor 62 configured as such may allow the fan width or other characteristics of the stream 42 to be determined and, possibly, adjusted in real-time while a substrate is coated.

The coating system 10 includes a pressurized liquid supply 38 that operates in a known manner under the command of controller 18 to generate a continuous stream or supply of the pressurized liquid coating material. For example, the pressurized liquid supply 38 may include a diaphragm or piston pump that siphons amounts of liquid coating material from a reservoir and then pumps the stream of liquid coating material under pressure from the reservoir through a fluid path to the applicator 16. The pressurized liquid supply 38 is electrically connected by a communication link 39 with the controller 18, which can regulate operating parameters such as the temperature and pressure of a liquid coating material by communicating appropriate control signals to the pressurized liquid supply 38 over communication link 39.

The pressurized liquid supply 38 is optionally configured with one or more conventional heating elements 38a that are electrically coupled with a conventional temperature controller 60 that is electrically coupled with the controller 18. The construction and operation of conventional heating elements, such as heating elements 38a, and temperature controllers, such as temperature controller 60, are understood by a person having ordinary skill in the art. In an alternative embodiment, the applicator 16 may include heating element (not shown) or a heating element (not shown) may be disposed in the one of the conduits 51, 53, 55. Regardless of the specific location of the heating element in the flow path between the pressurized liquid supply 38 and the nozzle 31, the liquid coating material may be heated in this flow path before being applied to the substrate 12.

The applicator 16 includes a liquid inlet 36 that is coupled in fluid communication with a pressurized liquid supply 38. The liquid coating material is supplied from the pressurized liquid supply 38 to the applicator 16 through the liquid inlet 36 for regulated dispensing out of a dispensing orifice (not shown) in the nozzle 31. The body 30 has a fluid inlet 40 coupled with pressurized fluid supply 32 and internal passageways (not shown) that direct the pressurized fluid to outlets in the vicinity of the dispensing orifice in nozzle 31, where the pressurized fluid is discharged to interact with and manipulate the stream 42 of liquid coating material that is sprayed from the applicator 16. A fluid regulator 43, which communicates over communication link 45 with motion controller 26, controls the flow of pressurized fluid from the pressurized fluid supply 32 to the fluid inlet 40. A representative applicator similar to applicator 16 is described in U.S. Pat. No. 7,028,867.

The coating system 10 is operated as instructed by a library of operational cycles or sequences that are stored in a memory 44 associated with the controller 18 and/or stored in other computers. The operational sequences are recalled and placed in a particular operational program, as desired, executing on the controller 18. The operational sequences can be adjusted to accommodate different environmental conditions, different types of substrates 12, or different types of conformal coating material. During operation, the controller 18 can transfer an entire operational program as electrical signals over communication link 25 to the motion controller 26 for execution at the motion controller 26. Alternatively, the controller 18 can transfer one or more instructions as electrical signals over communication link 25 in a batch of instructions and data to the motion controller 26 for subsequent execution. The operator may enter parameters, such as the type of substrate 12, an identifier of substrate 12, a description of substrate 12, the type of liquid coating material, the liquid pressure, the assist air pressure, the velocity of the applicator 16, the distance between the substrate 12 and applicator 16, etc., at the HMI device 19. The entered parameters are stored in the memory 44 of controller 18 for future use in an operational sequence. Each substrate 12 is matched by the controller 18 with a coating program that determines which specific components and areas of the substrate 12 are to be coated with liquid coating material. Typically, the liquid coating material is applied to only selected areas and/or components on the substrate 12.

An "air over fluid" (A/F) regulator 50 and a flow meter 52 are situated in the flow path for the liquid coating material from the pressurized liquid supply 38 to the liquid inlet 36 of the applicator 16. As a result, the liquid coating material is constrained to flow through the A/F regulator 50 and flow meter 52 in transit from the pressurized liquid supply 38 to the applicator 16. A liquid input of the A/F regulator 50 is coupled by a conduit 51 with a liquid outlet of the pressurized liquid supply 38. Similarly, the A/F regulator 50 has a liquid outlet coupled by a conduit 53 with a liquid input of the flow meter 52, which in turn has a liquid outlet coupled by a conduit 55 with the liquid inlet 36 of the applicator 16.

The A/F regulator 50 controls the fluid pressure of the pressurized liquid material in transit in the fluid path to the applicator 16. The controller 18 is electrically coupled by a communication link 57 with a regulator 54. In one embodiment, the regulator 54 may be a "voltage over pressure" (E/P) regulator that receives a control voltage from the motion controller 26 and includes a transducer that converts the control voltage to a fluid pressure. Alternatively, the regulator 54 may receive a control current or a serial communications signal, instead of a control voltage, for conversion to a fluid pressure. The regulator 54 delivers pressurized fluid to the A/F regulator 50 for use in controlling the fluid pressure of the liquid coating material flowing through the A/F regulator 50.

The A/F regulator 50 is positioned in a conduit 35 defining a fluid path between the pressurized liquid supply 38 and the flow meter 52. In an alternative embodiment, the flow meter 52 may be positioned in the fluid path between the pressurized liquid supply 38 and the A/F regulator 50 so that the flow meter 52 is upstream from the A/F regulator 50. With this alternative arrangement, the A/F regulator 50 would alter the pressure of the liquid coating material after the liquid coating material has flowed through the flow meter 52.

The controller 18 is electrically coupled by a communication link 59 with the flow meter 52. In response to the flow of liquid coating material from conduit 53 to conduit 55, the flow meter 52 generates a string of counts or electrical pulses each representing a fixed volume of liquid coating material flowing through or past the flow meter 52. Alternatively, the string of electrical pulses from the flow meter 52 may be communicated from the flow meter to the motion controller 26 and then relayed from the motion controller 26 to the controller 18. In one embodiment, the flow meter 52 may comprise a gear meter that rotates in response to flow through the gear meter and, for a fixed amount of rotation representing a known volume, generates an electrical pulse with an encoder that is transmitted as an electrical signal in a signal stream to the controller 18. For example, the gear meter may generate a pulse for every 0.04 cubic centimeters of liquid coating material flowing through the flow meter 52. In another embodiment, the flow meter 52 may comprise a thermal mass flow meter.

In use, the controller 18 obtains a coating program for the substrate 12 when substrate 12 is properly positioned relative to the applicator 16. The coating program determines which components and/or areas of the substrate 12 are to be coated with liquid coating material, which is usually applied in strips. For example, possibly twenty-five separate components or areas of a substrate 12 may be coated with strips of the liquid coating material. The controller 18 retrieves an operational sequence from the memory 44 of controller 18 and, in turn, communicates control signals to the motion controller 26 over communication link 25 representing the operational sequence. The motion controller 26 sends command signals to the robot 14 over communication link 21 that instruct the robot 14 to move the applicator 16 at specified velocities to desired locations with respect to the substrate 12. The motion controller 26 controls the movements of the robot 14 to move the applicator 16 in a plane (e.g., X and Y directions) across the substrate 12, opening and closing the dispensing valve in the applicator 16 as necessary during this movement to apply the liquid coating material to the desired components and areas of the substrate 12.

Specifically, at any particular location on substrate 12, the motion controller 26 also provides a command signal to the solenoid 34 to cause it to change state to open the dispensing valve causing discharge of liquid coating material from nozzle 31. Concurrently, the motion controller 26 provides command signals to the robot 14 to initiate motion of applicator 16 relative to the substrate 12. The stream 42 of liquid coating material may be optionally manipulated by an assist fluid, such as air, that affects the shaping of the stream 42 discharged from the applicator 16. After a predetermined time lapses, the motion controller 26 subsequently changes the state of the valve command signal to return the solenoid 34 back to its original state. This action closes the dispensing valve to discontinue the discharge of liquid coating material from the nozzle 31 of the applicator 16. The motion controller 26 may cause the dispensing valve of the applicator 16 to open and close the dispensing valve multiple times (e.g., twenty-five times) during the extent of the coating program so that multiple components and areas of the substrate 12 receive an amount of liquid coating material.

During the coating program or in preparation for the execution of the coating program, the controller 18 provides electrical signals to the motion controller 26, which prompt the motion controller 26 to provide command signals to the regulator 54. The regulator 54 controls an air pressure supplied to the A/F regulator 50 to selecting a liquid pressure for the pressurized liquid coating material flowing from the pressurized liquid supply 38 to the applicator 16. The selected value of liquid pressure, which is dispensing application dependent, may further depend on the desired flow rate of the liquid coating material. The flow rate for the liquid coating material is influenced, among other factors, by the liquid pressure, the diameter of the discharge orifice in the dispensing nozzle 31, the material viscosity, etc.

The reader is again reminded that any teachings made with respect to, for example, a particular apparatus type, mode of operation, or material may apply equally to all other types of apparatus, mode of operation, and material, unless clearly indicated otherwise by express statement and/or context. Thus, any teachings made in describing each of the systems of FIGS. 2A and 2B are equally applicable to one another. Likewise, any other teachings elsewhere herein that reference one of the systems of FIGS. 2A and 2B may also apply to the other.

With attention back to FIGS. 1 and 2A, after the operation to dispense the fluid to the substrate 114 is complete, the coated substrate 114 is transported (e.g., via the conveyor 122) to the inspection station 130. The inspection station 130, using one or more sensors, may measure and/or determine a value of a characteristic of the fluid that is applied to the substrate 114 (which may be referred to herein as a "coating characteristic"). For example, the inspection station 130 may measure the placement of the fluid in relation to the substrate 114 and/or in relation to other portions of the fluid on the substrate 114. In a related example, the inspection station 130 may measure a shape and other related characteristics of a coated material formation. The inspection station 130 may measure, for example, the dimensions and proportions of a fluid formation placed between two rows of components.

As yet another example of a coating characteristic, the inspection station 130 may measure the thickness of the fluid that is applied to the substrate 114 or portion thereof. In any of the above examples, the measured value of the coating characteristic may represent only a subset of the fluid applied to the substrate 114. For example, one value of a coating characteristic may refer to the fluid applied to a first subset of the substrate 114 and a second value of the coating characteristic may refer to the fluid applied to a second subset of the substrate 114. Such may be the case, for example, if one area the substrate 114 is to receive one thickness of fluid and a second area of the substrate 114 is to receive a second, different thickness of fluid. Subsets of fluid on the substrate 114 may also be defined by discrete (i.e., non-contiguous) formations of fluid. The thickness of fluid may be measured by a sensor, such as a wet film gauge, an ultrasonic gauge, a laser sensor, and/or a sensor using eddy currents (not shown).

In one embodiment, the inspection station 130 may measure a value of a coating characteristic of the fluid applied to a pre-determined location on a substrate 114. For example, a location on a substrate 114 may be designated as a "sample area." The sample area may be located on an area of the substrate 114 that is void of any functional components and preferably flat. This may serve to isolate a target coating characteristic of the fluid from other variables that may be otherwise introduced at other locations on the substrate 114. For example, the vertical aspect of a component may make it difficult to accurately measure some coating characteristics, such as fluid thickness, for the fluid applied to the area with the vertical component. In addition, a misplacement or misalignment of a component may cause an associated formation of fluid to appear as if the fluid were incorrectly placed in relation to that component when, in fact, the placement of the formation in relation to the substrate 114 as a whole was correct. It is merely the misaligned or misplaced component that is causing the false positive with respect to the fluid formation's placement. The sample area on the substrate 114 may be visually marked on the substrate 114 to visually identify a target area for application of the sample fluid.

An application and subsequent measurement of sample fluid on this designated sample area may not be performed for each coated substrate 114. Instead, it may be performed at pre-determined intervals with respect to a number of coated substrates 114 (e.g., every 50 substrates), a number of inspections (e.g., every ten inspections of a substrate 114), or elapsed time (e.g., every one hour). An application of fluid to the sample area and measurement thereof may also be responsive to an operator's input. It is noted that the sample area may accommodate applications of multiple fluid formations such as multiple dots or beads of fluid.

The value of the characteristic of the fluid on the substrate 114 may be communicated to and stored at the controller 132 for processing. As additional, subsequent substrates 114 in a series of substrates 114 are coated by the coating assembly 104 and conveyed to the inspection station 130, the inspection station 130 may likewise measure the value of the coating characteristic for each sequential substrate 114 and communicate that data to the controller 132.

As a brief aside, the controller 132 may be configured with a processor, memory (volatile and/or non-volatile), and various communication interfaces. The memory, for example, may store instructions that, when executed by the processor, cause the processor to effectuate various operations indicated in the instructions. Examples of such operations will be provided herein. The controller 132 may be in communication with various components of the system 100, including the coating assembly 104, the dispenser 108, the conveyor 122, the inspection station 130, the curing oven 102, and any sub-components thereof. The controller 132 may manage the cooperative operations of the various components of the system 100. The operating parameters, according to which the various components operate, may be set and/or adjusted by the controller 132. As such, the controller 132 may maintain the operating parameter values for many of the components of the system 100. This may facilitate execution of those portions of the disclosed techniques in which the controller 132 adjusts the value of an operating parameter of a component in response to a determination or estimate that the tolerance value for a coating characteristic will be, or is likely to, be exceeded.

The controller 132, as illustrated in FIG. 1, is coupled to the inspection station 130. The disclosure, however, is not so limited. The controller 132 may be connected to or integrated with any of the components of the system 100. Alternatively, the controller 132 may form a stand-alone unit. The controller 132 may be further configured with a display for visual output to an operator and one or more input devices (e.g., a keyboard and mouse) for an operator to provide input to the controller 132. For example, an operator may interact with the controller 132 to provide a manual intervention to operation of the dispenser 108 if the controller 132 determines or estimates that a fluid characteristic will, or is likely to, exceed a threshold.

As already noted, the controller 132 is in communication with the inspection station 130 and may receive and store data transmitted from the inspection station 130, including data indicating a value of a coating characteristic. The controller 132 may iteratively receive and store data from the inspection station 130 that reflects respective values of a coating characteristic for each of a sequential set of coated substrates 114 that have each been inspected. This body of data may represent a "time" series of values of a coating characteristic for a set of sequential inspected substrates 114. It is noted, however, that the set of sequential inspected substrates 114 need not represent all substrates 114 coated within the corresponding period of time. Rather, some substrates 114 may be coated but not inspected in the intervening time between inspection of two other coated substrates 114. The "time" aspect of the time series may refer to inspected coated substrates 114 (or merely coated substrates 114, whether inspected or not) in a series of sequential inspected coated substrates 114. Although the "time" aspect of the time series also may be considered in its typical sense, i.e., elapsed chronological time.

Using this data that reflects the respective values of a coating characteristic of the fluid on two or more substrates 114, the controller 132 may analyze that data to determine or estimate if a future value of that coating characteristic will, or is likely to, exceed a tolerance value (e.g., fall outside of a threshold range) of that coating characteristic in a subsequent iteration of applying fluid to another substrate 114. If the controller 132 determines that a future value of the coating characteristic will, or is likely to, exceed the tolerance, the controller 132 may also determine or estimate when the tolerance will, or is likely to, be exceeded.

Various prediction and statistical modeling, trend estimation, and/or time series forecasting techniques may be applied to the coating characteristic value data received from the inspection station 130. For example, linear regression techniques may be applied to a linear representation of the time series of the coating characteristic values, as taken over the series of inspected coated substrates 114. In other words, the values of the coating characteristic may form the Y axis of a line chart and the series of sequential coated substrates 114 may form the X axis of the line chart. For example, the data points on the X axis may be for, respectively, a first coated substrate 114, a second coated substrate 114, a third coated substrate 114, and so forth. Each of the coating characteristic value: coated substrate pairs may be represented on the line chart as a data point. The linear regression process or the like may determine a trend line for these data points. The value at which a tolerance for a coating characteristic is exceeded may be cross-referenced in the trend line to determine the corresponding number of coated substrates 114 (or other metric) at which the tolerance will be, or is likely to, be exceeded. It will be noted that references herein to "when" a tolerance will, or is likely to, be exceeded may refer to chronological time or another metric, unless clearly indicated otherwise by express statement or context. Examples of other metrics besides chronological time may include a number of substrates coated or a number of coated substrates inspected. Of course, one may be extrapolated from another if a coating and/or inspection rate (with respect to time) is known.

If the controller 132 determines or estimates that a tolerance value for a coating characteristic will be, or is likely to be, exceeded, the controller 132 may adjust one or more operating parameters of a component of the system 100. For example, an operating parameter of the dispenser 108 may be adjusted. Examples of an operating parameter of the dispenser 108 that may be adjusted by the controller 132 include 1) a fluid pressure at which fluid is provided to the nozzle 134, 2) an air pressure according to which one or more air jets apply air to the fluid as it exits the nozzle 134, 3) the timing between coating applications, 4) the position of the dispenser 108 and/or nozzle 134 (e.g., the vertical distance between the nozzle 134 and the substrate 114), 5) an actuation timing of the actuator 144 and/or drive pin 138, 6) the flow rate of fluid (i.e., volume per unit of time) supplied to the nozzle 134, and/or 7) the speed and/or rate of opening and closing the valve 136. As an operating parameter of the coating assembly 104, the fluid (or attribute thereof) supplied by the fluid source 106 may be changed, such as with respect to viscosity of the fluid. Other operating parameters that may be adjusted include the speed at which the conveyor 122 transports substrates 114 or the general rate at which the coating assembly's 104 coating process is performed and/or the coating and inspection process together is performed. Additional examples of operating parameters that may be adjusted include the intensity of heat applied in the curing oven 102 or the length of time in which the coated substrate 114 remains in the curing oven 102.

The adjustment of the operating parameter preferably will result in a new value that slows or stops the trend of the coating characteristic value towards the tolerance value limit. It is also preferable that the new value to which the operating parameter is adjusted reverses the trend towards the tolerance value limit and begins to bring the value of the coating characteristic towards a target value. Even more preferably, the new operating parameter value results in the coating characteristic value being within the tolerance range at the next inspection.

After the coated substrate 114 is inspected at the inspection station 130, the coated substrate 114 is moved, such as by the conveyor 122, to the curing oven 102 for the fluid to be cured. The curing oven 102 has an interior volume 110 and one or more heating zones 112. Each heating zone 112 receives the coated substrate 114 and heats the environment within the heating zone 112 to a predetermined temperature. The substrate 114 may be moved on a conveyer belt, such as the conveyor 122. It is noted, however, that the conveyor 122 need not comprise a single conveyor belt, but may be formed from a series of conveyor belts. In one embodiment, each heating zone 112 may be an enclosure that is separated from the rest of the oven by physical borders or dividers. In another embodiment, each heating zone 112 may be a region of the oven 102 that is not physically divided from the rest of the oven. In some embodiments, the heating zone 112 may be defined by the interior volume 110 of the curing oven 102, such that the heating zone 112 is in fluid communication with the interior volume 110.

The temperature in each heating zone 112 may be fixed, or it may be adjusted during the heating process. The transition between one heating zone and an adjacent heating zone may be gradual and may include a temperature gradient ranging from the temperature of the first heating zone 112 to the temperature of the second heating zone 112. In some embodiments, part of the interior volume 110 that defines a first heating zone 112 may also define a second heating zone 112, such that the heating zones 112 overlap.

The system 100 may include one or more vents. A first vent 116 may be connected to the curing oven 102 to allow movement of gases, such as evaporated solvent, from inside the curing oven 102 to an environment external to the curing oven 102. A second vent 117 may be connected to the coating assembly 104. The second vent 117 may allow a flow of gases from within the coating assembly 104 to an environment external to the coating assembly 104. One or more of the first and second vents 116, 117 may be configured with a regulator 118 (shown in schematic in connection with the first vent 116) that can be adjusted to vary the rate at which evaporated solvent or other gases can flow from within the volume 110 of the curing oven 102 and/or from within the coating assembly 104 to the environment external to the curing oven 102 and/or the coating assembly 104, respectively. The regulator 118 may include a baffle, a gate, a valve, or another suitable device that can be adjusted to permit or block the passage of the evaporated solvent or other gas. One or more of the first and second vents 116, 117 may be configured with a fan 120, the operation of which may create a negative pressure within the volume 110 of the curing oven 102 and/or the interior of the coating assembly 104, as the case may be. Other types of curing systems may be additionally or alternatively implemented in the system 100, such as a UV curing system, a batch oven curing system, or an air temperature curing system.

In an alternative embodiment, the inspection station 130 may be configured to receive the substrate 114 for inspection after the coating on the substrate 114 is cured. For example, the arrangement of the coating assembly 104, the inspection station 130, and the curing oven 102, as shown in FIG. 1, may be altered such that the curing oven 102 is positioned between the coating assembly 104 and the inspection station 130. As a result, the coating assembly 104 may apply fluid to the substrate 114 and the coated substrate 114 may be passed to the curing oven 102 in which the fluid on the substrate 114 is cured. The coated and cured substrate 114 may be then passed to the inspection station 130. The inspection station 130 may measure various coating characteristics of the cured fluid in the same or similar manner as when inspecting the uncured fluid directly after the fluid was applied to the substrate 114. The coating characteristics of the cured fluid may include the same or similar coating characteristics as those discussed above in relation to the un-cured fluid.

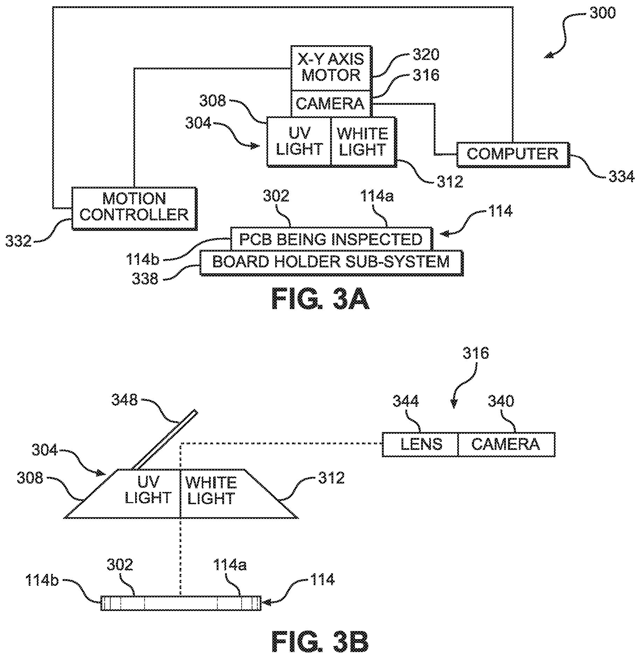

In another alternative embodiment, the inspection station 130 or portions thereof (e.g., the components shown in FIGS. 3A and 3B), may be integrated with the coating assembly 104. In such an embodiment, the housing 131 of the inspection station 130 may be omitted. Therefore, the coated substrate 114 may be directly transferred to the curing oven 102 after the substrate 114 is coated and, if applicable, the coated substrate 114 may be inspected by the integrated inspection station 130. In this embodiment, the coating assembly may be configured with two movable arms: one for moving and positioning the dispenser 108 and another for moving and positioning at least some components of the inspection station 130. For example, a camera and/or a light source (e.g., a UV light source and/or a white light source) may be fixed to one of the movable arms. In operation, the dispenser 108 may be positioned and selectively repositioned above the substrate 114 while applying the fluid to the substrate 114 and the other arm holding the inspection components may be positioned aside. After the coating operation is complete, the dispenser 108 may be moved aside and the inspection components may be positioned and selectively repositioned above the substrate 114 to inspect the fluid thereon. In another example, both the dispenser 108 and the inspecting components may be affixed to a single movable arm. In this case, the movable arm may be positioned and selectively repositioned according to whether a coating operation or an inspection operation is underway.

To position the dispenser 108 and/or the inspection components during the respective operation, the movable arm(s) may move over the X, Y, and Z axes of the substrate 114 while the substrate 114 is held stationary. Alternatively, one or more axes of movement may be performed by the movable arm and the substrate 114 may be moved over one or more of the other axes of movement. For example, the movable arm may move over the X and Z axes (i.e., one direction parallel to the planar surface of substrate 114 and one direction perpendicular to the planar surface of the substrate 114) and the substrate 114 may be moved over the remaining Y axis. Additionally or alternatively, inspection components may be fixed to a static support.

With continued reference to FIGS. 1 and 2A, FIG. 3A illustrates an example configuration of an inspection system 300 and FIG. 3B illustrates a camera sub-system 316 associated with the inspection system 300. The inspection station 130 and other relevant components of the system 100 may be configured in a same or similar manner as illustrated in FIGS. 3A and 3B.

The inspection system 300 may include a lighting sub-system 304 that has an ultraviolet (UV) light source 308 that directs UV light onto the fluid 302 applied to the substrate 114 (identified as "PCB BEING INSPECTED" in FIG. 3A). The fluid 302 may include a tracer that fluoresces in the presence of the UV light. The lighting sub-system 304 also may include an optional white light source 312 that directs white light onto the fluid 302 on the substrate 114. The inspection system 300 further includes the camera sub-system 316 (illustrated in detail in FIG. 3B) that includes a camera 340. The camera 340 has a lens 344 positioned above the substrate 114 for capturing one or more images of the illuminated substrate 114 when light is emitted onto the substrate 114. Specifically, the camera 340 can be angled or positioned perpendicular to the confronting surface 114a of the substrate 114. When positioned perpendicular to the confronting surface 114a, as shown in Figure 3B, the inspection system 300 may include an angled mirror 348. Though depicted in FIG. 3A as being situated above the substrate 114 and in FIG. 3B as perpendicular to the substrate 114, the camera 340 may be angled, e.g., at a 45° angle, relative to the confronting surface 114a of the substrate 114 so that the lens 344 captures one or more edge images of an outer edge 114b of the illuminated substrate 114. The images from the camera 340 are conveyed to an image-processing computer 334, which may be integrated with the controller 132 or operate in cooperation with the controller 132, for determining whether the substrate 114 is properly coated. Alternatively, the image-processing computer 334 may be separate from but in electronic communication with the controller 132. The image-processing computer, or other applicable component of the system 100, may apply various image processing techniques, such as object recognition, pattern recognition, or feature (lines, corners, interest points, etc.) evaluation, to determine the values of the various coating characteristics.

The inspection system 300 may also include a board holder sub-system 338 configured to support the substrate 114 while the substrate 114 is inspected. The board holder sub-system 338 may be configured to hold the substrate 114 about one or more of its edges during inspection. In another embodiment, the board holder sub-system 338 may include support pins (not shown) that holds the substrate 114 during inspection. To adjust the position of the camera sub-system 316, the camera sub-system 316 may be connected to an X-Y axis motor 320. The X-Y axis motor 320 is configured to move the camera sub-system 316 relative to the substrate 114 upon receiving instructions from a motion controller 332 and/or the image-processing computer 334. As with the image-processing computer 334, the motion controller 332 may be integrated with the controller 132 or, alternatively, may be separate from but operate in cooperation with the controller 132. Though one type of inspection device is described, the inspection system 300 may include various other types of inspection devices as desired, such as a laser sensor to measure coating thickness on a substrate.

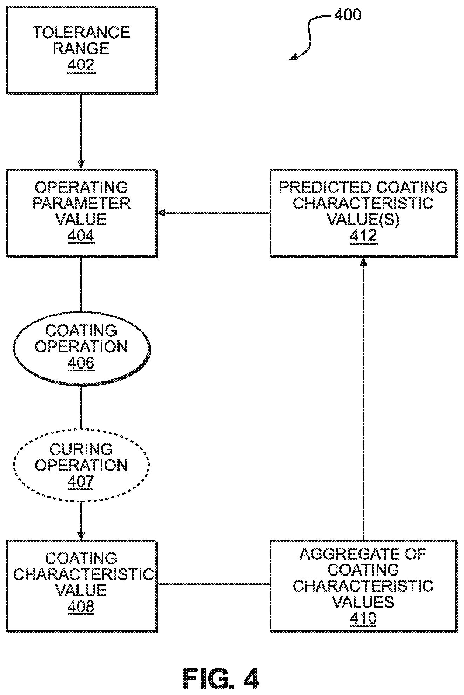

FIG. 4 illustrates a data flow diagram 400 that represents, at least in part, a process of enhanced coating dispensing controls according to an embodiment of the present disclosure. Although reference is made to a coating material, a coating operation, a coating system, and other coating terms, the disclosure is not so limited. The various components of the diagram 400 and descriptions thereof apply equally to all types of apparatus (e.g., a needle-type dispenser), operations (e.g., a jetting operation), and materials (e.g., a viscous material).

By way of introduction, a coating system (e.g., the system 100 of FIG. 1) generally performs coating operations according to the respective values of a number of various operating parameters of the coating system. An instant coating operation 406 is performed according to a current operating parameter value 404 to apply fluid to a substrate (e.g. the substrate 114). The operating parameter is a parameter of the coating that affects the value of a relevant coating characteristic. The current value of the operating parameter is preferably within an acceptable tolerance range 402, but is not necessarily so. The fluid on the substrate is then inspected to determine a coating characteristic value 408 for a characteristic of the fluid. An aggregate of coating characteristic values 410 is updated based on the instant coating characteristic value 408. The aggregate of coating characteristic values 410 is analyzed to determine and/or estimate one or more future predicted coating characteristic values 412 for the fluid on subsequent coated substrates. Based on the predicted coating characteristic value(s) 412, the operating parameter value 404 is adjusted, if needed, to preferably prevent the coating characteristic value for a subsequent substrate from falling outside of the tolerance range 402, thereby avoiding a fault or defect with the subsequent substrate.

The tolerance range 402 may refer to a range of values that are deemed acceptable, such as by the substrate manufacturer or their customers. The values of the tolerance range 402 may correspond with a particular coating characteristic of fluid that is applied to a substrate. The various types of coating characteristics shall be described below in reference to the coating characteristic value 408. The tolerance range 402 may include an upper value and a lower value. Although in some instances, the tolerance range 402 may include, in actuality or in practice, only one of an upper value or a lower value.

In some embodiments, the tolerance range 402 may include multiple sets of tolerance ranges, with one inside the other. Two ranges may indicate, for example, a low-level warning and a high-level warning. The multiple ranges may be used in comparing the predicted coating characteristic value(s) 412 to the tolerance range 402 and/or in determining the adjustment to the operating parameter value 404. In an example, the predicted coating characteristic value(s) 412 being outside of an outermost tolerance range may result in a greater adjustment to the operating parameter value 404 while the predicted coating characteristic value being outside of the inner tolerance range but inside the outer tolerance range may result in an adjustment of the operating parameter value 404 to a lesser degree.

The operating parameter value 404 may represent a value of an operating parameter relating to the coating system, a component of the coating system, or any other variable relating to the operation of the coating system but not strictly part of the coating system itself. The operating parameter may be any parameter that may materially affect a coating operation and/or a fluid applied to a substrate. e.g., the coating characteristic value 408.

An operating parameter may include an operating parameter of the coating dispenser (e.g., the dispenser 108 of FIG. 1), such as the fluid pressure or flow rate of the fluid that is supplied from a fluid source and/or to the nozzle of the coating dispenser. Another operating parameter of the coating dispenser may include a rate at which the coating dispenser applies various formations (e.g., dots) of fluid to the substrate or a speed at which the dispenser is moved in relation to the substrate while performing the coating operation. An operating parameter of a coating dispenser may also include any parameters relating to the fluid dispensing itself, such as the velocity of the fluid as it exits the nozzle, the dimensions, shape, or directionality of the fluid while in flight between the nozzle and the substrate. An operating parameter of a coating dispenser may relate to the positioning of the coating dispenser, such as the distance between the nozzle and the substrate.

Yet another example associated with a coating dispenser includes an operating parameter relating to the fluid source, such as the flow rate and or fluid pressure at which it supplies fluid. Another example operating parameter may relate to an actuator and/or drive pin/valve seat arrangement, such as an actuation frequency or speed, or an impact force of the drive pin to the valve seat. Another example operating parameter may relate to an air stream (e.g., from an air jet) to which fluid is subject as it is dispensed from the nozzle, including air pressure or the directionality of the air.

Other example operating parameters may relate to the overall speed at which a series of substrates are moved through and coated by the coating dispenser. More generally, an operating parameter may refer to the speed or rate at which a series of substrates are processed by the coating system as a whole. This may include the speed of one or more conveyors or other devices to move the substrate through the coating system. The aforementioned operating parameters relating to speed of operation may be increased, for example, if the coating characteristic value 408 remains stable over multiple iterations. Another example of an operating parameter relates to the properties of the fluid itself, such as its viscosity and/or temperature.

The coating operation 406 may be performed according to the operating parameter value 404. In particular, a volume of fluid is applied to at least some area of the substrate by the coating dispenser. The areas of the substrate to which the fluid may be applied include any electrical or other components positioned on the substrate, areas of the substrate that do not have a component (e.g., between two components), or any combination of the two, including an area that overlaps a border between a component and a non-component sub-area.

In addition and as already noted above, the fluid may be applied to a "sample area" of the substrate that is void of any components or functional aspects (other than those implemented primarily to further the use of the sample area). The sample area may be used as a surface to apply one or more volumes of fluid (e.g., in various formations, such as drops or lines). The fluid applied to the sample area may serve primarily as a test subject for measuring one or more characteristics of the fluid in isolation from other variables that may affect the measurement of the characteristic. For example, the three-dimensional and intricate nature of many components may hinder measurement of fluid thickness. Other faults introduced in earlier processes relating to the substrate may also interfere with certain measurements. For example, the components mounted on a substrate may be misaligned, thus causing fluid applied in relation to what should have been the correct alignment to appear as incorrectly positioned on the substrate. The sample area may be indicated by a dot or other marker. The dot or other marker may be used as a frame of reference in determining the true coating characteristic value of the fluid, particularly with respect to positioning of a coverage area. In addition, the sample area may be flat so that the fluid thickness, for example, may be more accurately measured.

In some embodiments, the substrate subject to the coating operation 406 may also undergo a curing operation 407 before the fluid on the substrate is inspected and the coating characteristic value 408 determined and/or measured. In this case, a curing oven (e.g., the curing oven 102 of FIG. 1) may be positioned between the inspection station or other similar component and the dispenser. Thus, a "coated substrate" or the like may be understood to also include a substrate that is both coated and cured, unless clearly indicated otherwise by express statement or context.

After the coating operation 406 (and optionally the curing operation 407) is complete, a value of a coating characteristic (i.e., the coating characteristic value 408) relating to at least some portion of the fluid applied to the substrate is determined. The coating characteristic value 408 may be determined by a camera or other sensor (e.g., the camera assembly 316 of FIGS. 3A and 3B). The sensor may be part of an inspection station (e.g., the inspection station 130 of FIG. 1) that is separate from the coating assembly and, thus, the coated substrate may require transport to the inspection station. Alternatively, the inspection station may be, at least in part, incorporated with the coating assembly or other component (e.g., the curing oven) of the coating system.

A coating characteristic may refer to the fluid covering one portion of the substrate, while another coating characteristic may refer to the fluid covering a second, different portion of the substrate, even if the coating characteristic are of the same "type." In an example, the coating characteristics for the two portions may both indicate the coating thickness at their respective portions of the coated substrate.

As an example, a coating characteristic may refer to the location of the fluid, or portion thereof, (i.e., the coating coverage area) in relation to the substrate as a whole or in relation to one or more specified components or other landmarks on the substrate. A portion of the substrate may include the "sample area" and/or target point thereof that is discussed above. As noted, the fluid may be applied to the substrate as a discrete formation, such as a dot or bead, a line (straight or looping), or an area-coat (i.e., a "swirl" pattern). Thus, the location of the fluid may refer to a particular fluid formation on the substrate.

A coating characteristic may refer to the location of the coating and/or coating formation in relation to a designated area of the substrate to which coating is intended to be applied. For example, the value of such a coating characteristic may indicate the percentage that the area has coverage and/or lacks coverage. Additionally or alternatively, the value of such a coating characteristic may indicate a percentage of a coating formation that is outside of its intended coverage area and/or the percentage that is inside the intended coverage area. The above percentage values may also be indicated by other quantitative metrics instead of percentages.

Additionally or alternatively, the location of the fluid may refer to a portion of a fluid formation. For example, a correctly-applied area coat formation may cover the area between two rows of components but without encroaching on any of the components. Yet an area coat formation may include a correctly-applied first section that covers a portion of the designated area without also being applied to any components. Said area coat formation may also include an incorrectly-applied second section that is offset from its intended location and fails to fully cover its intended area between the rows of components. In addition, the second section also covers some of the components. Thus, a location of fluid may refer to that faulty portion of the area coating formation rather than the location of the area coating formation as a whole.

Additionally or alternatively, the location of a fluid formation may be represented by a single location, such as a center point of the fluid formation. Thus, the overall location of a fluid location is the same as the location of the corresponding single location. Additionally or alternatively, the location of a fluid formation may be in relation to another fluid formation or a portion of the fluid. For example, a pair of dots of fluid may be intended to be placed a certain distance between the two. Thus the location of the first dot may be the frame of reference for indicating the location of the second dot.

As another example, a coating characteristic may refer to one or more dimensions or shapes of a fluid formation (or portion of the fluid). The dimensions of the fluid formation may include a width, length, diameter, or other distance between two points in the fluid formation. The shape of the fluid may include a circular shape, a dot, oval, linear, or ellipse shape, or an elongated shape. The shape of the fluid formation may refer to the relative proportions and angles of the width(s), length(s), or other dimensional aspects of the fluid formation, as well as any contours or other features defining the periphery of the fluid formation. The shape may be categorized according to one or more pre-defined shapes or characteristics, such as circular, oval, or elongated.

As yet another example, the coating characteristic may indicate that the fluid formation or other portion of the fluid is intended as a "sample" application. This coating characteristic may be determined by the location of the fluid formation or other portion of the fluid in a designated sample area of the substrate.

Another example of a coating characteristic may include a thickness of the fluid on the substrate as a whole, a fluid formation, or a portion of the fluid on the substrate. Here, thickness may be defined as the distance between a point on the substrate and an uppermost, vertically-corresponding point of the fluid. Vertical refers to the direction that is perpendicular to the planar surface of the substrate. In some examples, the thickness at a point or subset of points within a fluid formation may represent the thickness of that fluid formation. In other examples, the thickness of a fluid formation may be the least thickness value or the greatest thickness value over the various measured points of the fluid formation. Other coating characteristics include material volume, the flow rate of the material on the substrate, UV reflectivity, and refractive index.

Other examples of a coating characteristic may include an as-applied attribute of the fluid itself, such as electrical insulation, resistance to mechanical stress, vibration reduction, moisture permeability, and temperature insulation.

Additionally or alternatively, the a coating characteristic may include a composite of two or more of any of the coating characteristics described herein. For example, a coating characteristic may include a composite coating characteristic that reflects a location and a coating thickness of the fluid that is to be applied at that location.

The determined or measured coating characteristic value 408 may be added to an aggregate of coating characteristic values 410. The aggregate of coating characteristic values 410 may include coating characteristic values that were previously measured and/or determined and/or are associated with coated substrates that were previously coated and/or inspected before the instant coated substrate associated with the instant coating characteristic value 408. It is noted that not all coated substrates of the series of sequential coated substrates need be inspected. Rather, only a subset may be inspected, such as every fifth coated substrate in the series of sequential coated substrates.

In an example, the coating characteristic values of the aggregate of coating characteristic values 410 may be ordered and/or configured to facilitate determining the predicted coating characteristic value(s) 412. The coating characteristic values may be each associated with a corresponding coated substrate in the series of sequential substrates. Thus, the coating characteristic values in the aggregate of coating characteristic values 410 may be ordered according to the ordering of the series of sequential coated substrate. Additionally or alternatively, the coating characteristic value 408 and other coating characteristic values may be associated with a time or incorporate a timestamp by which the values of the aggregate of coating characteristic values 410 may be ordered. The aggregate of coating characteristic values 410 may be organized as a time series of the coating characteristic values. The time series may be represented on a two-axes line chart with one axis representing time (or analogous metric) and the other representing coating characteristic values. As noted above, the "time" aspect of the time series may refer to either chronological time or the order of inspected coated substrates (or merely coated substrates, whether inspected or not) in the series of sequential coated substrates 114.

In another example, the aggregate of coating characteristic values 410 may indicate neither times, the associated coated substrates, nor any other indication of relative ordering between the coating characteristic values. In this case (or others), the coating characteristic values in the aggregate of coating characteristic values 410 may be unordered and/or incapable or being ordered.

The aggregate of coating characteristic values 410 may form at least one basis in determining and/or estimating the predicted coating characteristic value(s) 412. The predicted coating characteristic value(s) 412 may include one or more (predicted) coating characteristic values of the fluid that will be applied to a substrate at a future time. The above term "future" or the like may refer to chronological time or the order within the series of sequential coated substrates.

The predicted coating characteristic value(s) 412 may be considered "predicted" if determined and/or estimated with a pre-determined confidence level, such as 90%, 95%, or 99% confidence. Thus, the predicted coating characteristic value(s) 412 need not be an absolute surety. Other indicators of confidence or similar concepts may be used in addition or in the alternative. Thus the confidence level or other similar metric may serve as a threshold requirement for a predicted coating characteristic value to be considered valid. Additionally or alternatively, the confidence level or other metric may be used in other portions of the process. For example, the confidence level or other metric may be one factor by which the new operating parameter value 404 may be determined for a following iteration of the process. In this example, a high confidence level may warrant a greater adjustment to the operating parameter value 404, while a lower confidence level may result in a more conservative or lesser adjustment to the operating parameter value 404.

The predicted coating characteristic value(s) 412 may be associated with a future substrate that is to be coated and/or inspected immediately following the instant coated substrate in the series of sequential coated substrates. Additionally or alternatively, the predicted coating characteristic value(s) 412 may be associated with a future substrate that does not immediately follow the instant coated substrate in the series of sequential coated substrates. Rather, there may be intervening coated and/or inspected substrates between the instant coated substrate and the future coated substrate that is associated with the predicted coating characteristic value(s) 412.

The predicted coating characteristic value(s) 412 may be analogous to the coating characteristic values of the aggregate of coating characteristic values 410 and the coating characteristic value 408. That is, each of the aforementioned values refer to the same underlying coating characteristic. For example, the coating characteristic value 408, the aggregate coating characteristic values 410, and the predicted coating characteristic value 412 may all refer to a coating thickness.

The predicted coating characteristic value(s) 412 may be determined via one or more prediction techniques applied to the aggregate of coating characteristic values 410, or part thereof. For example, it will be recalled that the aggregate of coating characteristic values 410 may form a time series with respect to coated substrate ordering, chronological timing, or other timing metric. The time series may be represented as various data points on a line chart. A linear regression and/or a curve/line matching technique may be used to determine a trend line or other functional representation. This trend line and/or function may be used to determine the predicted coating characteristic value(s) 412. Other techniques for time series forecasting may also be used.

In some embodiments, various techniques may be applied to the aggregate of coating characteristic values 410 to smooth a time series representation and/or apply variable weights to most recent data points in the time series. For example, a moving average technique may be used such as a simple moving average, a cumulative rolling average, a weighted moving average, and/or an exponential moving average. Another example technique is autoregressive-moving average (ARMA).

In an alternative embodiment, a particular coating characteristic value may be identified and a prediction technique may be used to predict the number of substrates (or other timing metric) that may be coated before the identified coating characteristic value is surpassed. For example, the identified coating characteristic value may be a tolerance range 402 value. The operating parameter value 404 may be adjusted according to this prediction instead of the predicted coating characteristic value 412.

The predicted coating characteristic value(s) 412 may include two or more predicted coating characteristic values. The multiple predicted coating characteristic values 412 may all be values of the same coating characteristic, but each may refer to a predicted coating characteristic value associated with separate coated substrates. For example, multiple predicted coating characteristic values 412 may refer to coating characteristic values of immediately subsequent substrates (e.g., the first, second, third, etc. substrates following the instant coated substrate). In another example, multiple predicted coating characteristic values may refer to subsequent coated substrates at some pre-determined interval from one another. For example, a first predicted coating characteristic value may predict a coating thickness on the coated substrate that is the fifth coated substrate from the instant coated substrate. A second predicted coating characteristic value may predict a coating thickness on the coated substrate that is the tenth coated substrate following the instant coated substrate, and so forth. The predicted coating characteristic value(s) 412 may include a pre-determined or operator-input number of predicted coating characteristic values, the number of which may reflect how far ahead an operator wishes the system to look in adjusting its operating parameters. The operator may additionally or alternatively indicate the interval between coated substrates to which the predicted coating characteristic value(s) 412 are directed.

The operating parameter value 404 may be adjusted (e.g., re-determined) to a new value based on the predicted coating characteristic value(s) 412. For example, the predicted coating characteristic value(s) 412 may be compared to one or more of the outer-most values of the tolerance range 402. The adjustment to the operating parameter value 404 may be based on this comparison and/or other factors. Generally, if the predicted coating characteristic value(s) 412 is outside of the tolerance range 402, the operating parameter value 404 may be adjusted, preferably to a value that is expected to cause the coating characteristic value in subsequent coated substrates (e.g., in further iterations of the process) to fall back within the tolerance range 402 or at least move towards being within the tolerance range 402. If the predicted coating characteristic value(s) 412 is within the tolerance range 402 but is closer to the outer limits of the tolerance range 402 than previously, the operating parameter value 404 may also be adjusted, such as to move the coating characteristic value away from the outer limit of the tolerance range 402. In some instances, the operating parameter value 404 may not be adjusted. The operating parameter value 404 may not be adjusted if, for example, the predicted coating characteristic value(s) 412 and the current coating characteristic value are the same or within some acceptable variance, such as 10% variance. Another instance in which the operating parameter value 404 is not adjusted may be when the predicted coating characteristic value 412 and the current coating characteristic value 408 are different, but the predicted coating characteristic value 412 is not outsider the tolerance range 402. As suggested by the above examples, the determination of the adjustment to the operating parameter value 404 may be based on the current coating characteristic value 408.

The adjustment is not necessarily limited to a single operating parameter. Rather, in some instances, multiple operating parameter values 404 may be adjusted to achieve a same or similar effect and/or under the same or similar criteria as if only a single operating parameter was adjusted.

It is generally contemplated that the iterations of the process be performed with respect to a single coating characteristic. For example, the process may be directed to the coating thickness at one particular location on the coated substrates. Yet in other instances, the process may separately track values for multiple coating characteristics (e.g., one for coating thickness and another for coating location) over several iterations. Predictions may be determined for the values of both of the coating characteristics and the operating parameters may be independently adjusted based on the predicted values for each coating characteristic.

Rather than operating parameter values being adjusted independently when multiple coating characteristic value are tracked, the value of a single operating parameter may be adjusted based on the predicted values of the two or more coating characteristics. The adjustment to the single operating parameter value 404 may be performed according to one or more criteria. For example, the single operating parameter value 404 may be adjusted to benefit both coating characteristics equally, such as causing both coating characteristic values to move "away" from an outer limit of their respective tolerance ranges by a proportionally equal amount. In another example, the single operating parameter may be adjusted to benefit each coating characteristic according to their proportionate distance "towards" the outer limit of their respective tolerance ranges. In another example, the operating parameter may be adjusted to affect the single coating characteristic that is most "towards" the outer limit of its tolerance range, which might reflect the coating characteristic that is more likely to first move outside of its respective tolerance range 402. In yet another example, the operating parameter value 404 may be adjusted to best benefit (e.g., move "away" from a tolerance limit) the two coating characteristics in the aggregate. In another example, the operating parameter value 404 may be adjusted based only on one of the coating characteristics and the benefit or detriment to another coating parameter is incidental. In an alternative to this example, adjustment of the operating parameter may be with regard to only the one coating characteristic until the other coating characteristic is predicted to be outside its tolerance range 402. In this case, the operating parameter may be adjusted to affect, in full or in part, the other coating characteristic.

Subsequent to the operating parameter value 404 being adjusted (or not) based on the predicted coating characteristic value 412, this iteration of the process may be considered complete. Another iteration may be performed with respect to a later coated substrate in the series of sequential coated substrates. The subsequent coated substrate subject to the next iteration of the process may be a coated substrate immediately subsequent to that in the previous iteration. Or the new coated substrate subject to the new iteration of the process may be a later substrate having some interval (by either chronological time or number of coated substrates) between it and the previously inspected coated substrate.

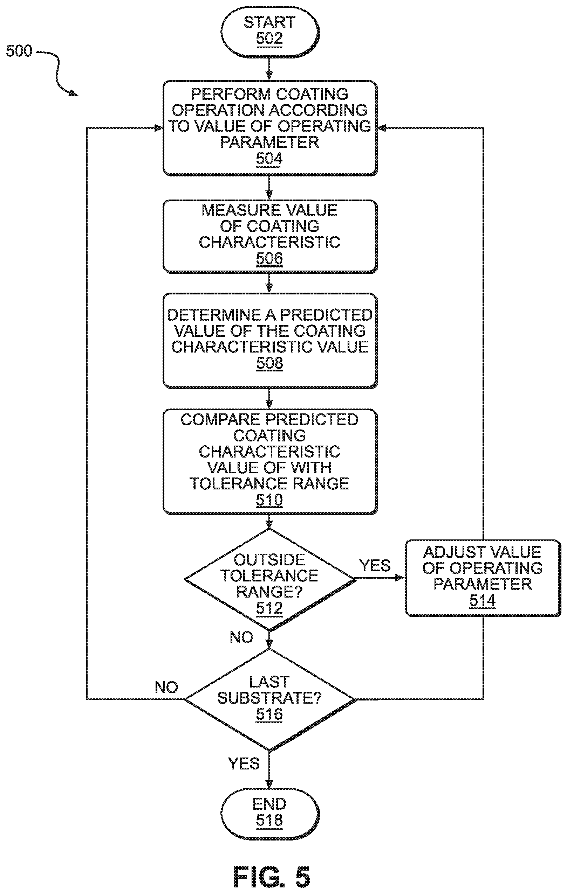

FIG. 5 illustrates a flow chart of a method 500 for performing a coating operation using enhanced coating control. The method starts at step 502. At step 504, a dispenser (e.g., the dispenser 108 of FIG. 1) may perform a coating operation to apply a fluid to at least some portion of a substrate (e.g., the substrate 114 of FIG. 1) according to the value of an operating parameter of the dispenser. In particular, the dispenser may include a nozzle having a valve that may be selectively opened and closed to dispense the fluid (e.g., the coating operation 406 of FIG. 4). The fluid may be applied as a dot, a line, or a spray area, as some examples. The substrate may be part of a series of subsequent substrates, such as the first substrate of said series.

The reader is again reminded that reference to a dispenser, a coating operation, a fluid, and other terminology used in describing the method 500 are to be understood broadly and may encompass any apparatus type, dispensing operation, and/or material type, unless clearly indicated to the contrary by express statement or context.

The coating operation may be performed according to an operating parameter value (e.g., the operating parameter value 404 of FIG. 4) that affects the value of one or more characteristics (e.g., the coating characteristic value 408 of FIG. 4) of the fluid as-applied to the substrate. The operating parameter may include, for example, a fluid pressure of the fluid as it is supplied to the nozzle and/or from a supply of fluid to the dispenser. As another example, the operating parameter may include an operating parameter of the nozzle, such as the speed at which the valve is opened or closed.

The coating characteristic value may include, for example, a thickness of the fluid applied to the substrate, a portion of the substrate, and/or a formation of fluid (e.g., a dot, line, or spray area). The coating characteristic value may also refer to a coverage aspect of the fluid. This may include the location of the coated substrate on the substrate and/or the size of the coated area, such as the dimensions and/or shape of a fluid formation. For example, a coating formation may overreach a target area to which the coating formation is to be applied but not extend beyond. Other examples of coating characteristics are described in greater detail herein.

At step 506, the value of the aforementioned coating characteristic on the coated substrate may be measured, such as by an inspection station (e.g., the inspection station 130 of FIG. 1). The inspection station or other component may use one or more sensors to measure the coating characteristic value, such as a camera. The inspection station may measure the coating characteristic value immediately subsequent to the substrate being coated, as shown in FIG. 1. In other implementations, the inspection station may be positioned in the coating system to measure the coating characteristic value after the fluid on the substrate is cured. For example, a curing oven (e.g., the curing oven 102 of FIG. 1) may be positioned between the dispenser and the inspection station.

At step 508, a predicted value of the coating characteristic value (e.g., the predicted coating characteristic value(s) 412 of FIG. 4) may be determined/estimated. The predicted value may refer to a predicted value of the coating characteristic value for a fluid that is later applied to a substrate that is after the instant substrate in a series of sequential substrates. The later substrate may be one immediately following the instant substrate or may be one that has a number of intervening substrates between it and the instant substrate. For example, the later substrate may the 10th substrate that is coated and/or inspected after the instant substrate. If one embodiment, multiple predicted coating characteristic values may be determined/estimated for multiple later substrates.

The predicted coating characteristic value may be determined based on the instant coating characteristic value. Additionally or alternatively, the predicted coating characteristic value may be based on an aggregate of past coating characteristic values (e.g., the aggregate of coating characteristic values 410 of FIG. 4), such as for the previously-inspected coated substrates of the series of substrates. The instant coating characteristic value may be now added to the aggregate. The aggregate of coating characteristic values may be organized as a time series. One or more of various forecasting and/or prediction techniques may be applied to the time series to determine the predicted coating characteristic value.

The determined coating characteristic value may have an associated confidence level or other metric indicating the statistical certainty of the prediction. The confidence level or other metric may act as a threshold for the prediction to be considered valid. Additionally or alternatively, the confidence level or other similar metric may be a factor according to which the operating parameter may be adjusted in step 514.

At step 510, the predicted coating characteristic value from step 508 may be compared to a tolerance range of values (e.g., tolerance range 402 of FIG. 4). At step 512, if the predicted coating characteristic value is outside of the tolerance range of values, the method may proceed to step 514. The comparison may be performed with an allowance of a specified percentage, such as 10%, of the predicted coating characteristic value and/or value(s) of the tolerance range of values. Reference to "about" the predicted coating characteristic value and/or the value(s) of the tolerance range shall be understood to mean a value that is plus or minus 10% of that value. Other similar uses of "about" shall be considered likewise.

In the embodiment in which multiple predicted coating characteristic values are determined for multiple later substrates, the comparison may be performed for each of those multiple predicated coating characteristic values. The steps 512 and on may be performed for each of the multiple predicted coating characteristic values, going in order of sequence.

At step 512, if the predicted coating characteristic value is not outside of the tolerance range of values, the method 500 may proceed to step 516.

At step 516, if the instant substrate is the final substrate or the method 500 is otherwise indicated to terminate, the method 500 may end at step 518.

Also at step 516, if the instant substrate is not the final substrate of the series of sequential substrates and there is no other indication to terminate the method 500, the method 500 may return to step 504 without adjustment to the value of the operating parameter. Upon returning to step 504, a new iteration of the method 500 (step 504 through step 516 in particular) may be undertaken in which a new coating operation is performed for a subsequent substrate in the series of sequential substrates. The subsequent substrate need not be the one immediately following the substrate of the previous iteration, but may be at some interval of substrates following the substrate of the previous iteration. The value of the operating parameter in this next iteration of the method 500 may be the same as the value of the operating parameter used in the previous iteration.

If the predicted value of the coating characteristic value is outside of the tolerance range of values at step 512 (i.e., represents an unacceptable predicted value), the value of the operating parameter may be adjusted at step 514. For example, the value of the operating parameter may be adjusted so that the coating characteristic value in subsequent iteration(s) of the method 500 is (or is expected to be) within the tolerance range of values or, at the least, closer to within the tolerance range of values. In some implementations, the values of multiple operating parameters may be adjusted to affect the coating characteristic value in subsequent iteration(s) of the method 500.

After the value of the operating parameter is adjusted, the method 500 may return to step 504, At step 504 in this next iteration, the coating operation may be performed using the adjusted value of the operating parameter. The method 500 in this next iteration may proceed to step 504 and so forth.

One skilled in the art will appreciate that the systems and methods disclosed herein may be implemented via a computing device that may comprise, but are not limited to, one or more processors, a system memory, and a system bus that couples various system components including the processor to the system memory. In the case of multiple processors, the system may utilize parallel computing.

For purposes of illustration, application programs and other executable program components such as the operating system are illustrated herein as discrete blocks, although it is recognized that such programs and components reside at various times in different storage components of the computing device, and are executed by the data processor(s) of the computer. An implementation of service software may be stored on or transmitted across some form of computer readable media. Any of the disclosed methods may be performed by computer readable instructions embodied on computer readable media. Computer readable media may be any available media that may be accessed by a computer. By way of example and not meant to be limiting, computer readable media may comprise "computer storage media" and "communications media." "Computer storage media" comprise volatile and non-volatile, removable and non-removable media implemented in any methods or technology for storage of information such as computer readable instructions, data structures, program modules, or other data. Exemplary computer storage media comprises, but is not limited to, RAM, ROM, EEPROM, flash memory or other memory technology, CD-ROM, digital versatile disks (DVD) or other optical storage, magnetic cassettes, magnetic tape, magnetic disk storage or other magnetic storage devices, or any other medium which may be used to store the desired information and which may be accessed by a computer. Application programs and the like and/or storage media may be implemented, at least in part, at a remote system.

As used in the specification and the appended claims, the singular forms "a," "an" and "the" include plural referents unless the context clearly dictates otherwise. Ranges may be expressed herein as from "about" one particular value, and/or to "about" another particular value. When such a range is expressed, another embodiment includes from the one particular value and/or to the other particular value. Similarly, when values are expressed as approximations, by use of the antecedent "about," it will be understood that the particular value forms another embodiment. It will be further understood that the endpoints of each of the ranges are significant both in relation to the other endpoint, and independently of the other endpoint.

Recitation of ranges of values herein are merely intended to serve as a shorthand method of referring individually to each separate value falling within the range, unless otherwise indicated herein, and each separate value is incorporated into the specification as if it were individually recited herein.

Throughout the description and claims of this specification, the word "comprise" and variations of the word, such as "comprising" and "comprises," means "including but not limited to," and is not intended to exclude, for example, other components, integers or steps. "Exemplary" means "an example of" and is not intended to convey an indication of a preferred or ideal embodiment. "Such as" is not used in a restrictive sense, but for explanatory purposes.

Disclosed are components that may be used to perform the disclosed methods and systems. These and other components are disclosed herein, and it is understood that when combinations, subsets, interactions, groups, etc. of these components are disclosed that while specific reference of each various individual and collective combinations and permutation of these may not be explicitly disclosed, each is specifically contemplated and described herein, for all methods and systems. This applies to all aspects of this application including, but not limited to, steps in disclosed methods. Thus, if there are a variety of additional steps that may be performed it is understood that each of these additional steps may be performed with any specific embodiment or combination of embodiments of the disclosed methods.

Unless otherwise expressly stated, it is in no way intended that any method set forth herein be construed as requiring that its steps be performed in a specific order. Accordingly, where a method claim does not actually recite an order to be followed by its steps or it is not otherwise specifically stated in the claims or descriptions that the steps are to be limited to a specific order, it is no way intended that an order be inferred, in any respect. This holds for any possible non-express basis for interpretation, including: matters of logic with respect to arrangement of steps or operational flow; plain meaning derived from grammatical organization or punctuation; the number or type of embodiments described in the specification.

## Claims

1. A method for controlling a dispensing system (100), the dispensing system being operated by a controller (132) and having a dispensing device (108) configured to apply a liquid or viscous material to a sequence of substrates (114) that are moved through the dispensing system, the method comprising:
operating the dispensing device (108) to apply a first amount of material to a first substrate (114) of the sequence of substrates according to a first value of an operating parameter of the dispensing system;
measuring, using a sensor (62), a value of a characteristic of the first amount of material applied on the first substrate (114) to obtain a measured value of the characteristic of the first amount of material applied on the first substrate (114);
determining, based on the measured value of the characteristic of the first amount of material applied on the first substrate (114), that a predicted value of a characteristic of a subsequent amount of material, after being applied on a subsequent substrate in the sequence of substrates according to the first value of the operating parameter of the dispensing system, is estimated to be outside of a range;
adjusting the value of the operating parameter to a second value in response to the determination, with a confidence level equal to or greater than a pre-determined threshold confidence level, that the predicted value of the characteristic of the subsequent amount of material, to be applied on the subsequent substrate, is estimated to be outside of the range, the pre-determined threshold confidence level defining a requirement to be met for the predicted value of the characteristic of the subsequent amount of material to be considered valid; and
applying, according to the second value of the operating parameter, a second amount of material from the dispensing device (108) to a second substrate (114) of the sequence of substrates,
wherein the characteristic of the first amount of material applied on the first substrate is different than a characteristic of the second amount of material applied on the second substrate.

2. The method of claim 1, wherein the characteristic of the first amount of material applied on the first substrate comprises at least one of a location on the substrate, a size, a shape, and a thickness.

3. The method of claim 1, wherein the operating parameter is associated with at least one of a fluid pressure of the material supplied to a nozzle (134) of the dispensing device, a flow rate of the material supplied to the nozzle, a dispensing rate of the material from the nozzle, a rate at which the sequence of substrates are coated, and an air pressure of an atomizing air jet of the dispensing device.

4. The method of claim 1, wherein the characteristic of the first amount of material is measured at a designated non-functional sample area of the first substrate (114), wherein the designated non-functional sample area of the first substrate comprises a target location and the characteristic of the first amount of material comprises a location of the first amount of material relative to the target location.

5. The method of claim 1, wherein the second value to which the operating parameter is adjusted is determined based also on the confidence level being equal to or greater than a reference confidence level.

6. The method of claim 1, wherein adjusting the value of the operating parameter to the second value is based on one or more characteristics of amounts of material applied on one or more respective substrates prior in the sequence of substrates to the first substrate,
wherein the one or more characteristics of the amounts of material applied on the one or more substrates prior to the first substrate are represented as time series data, and wherein adjusting the value of the operating parameter to the second value is based on the time series data, and wherein adjusting the value of the operating parameter to the second value includes applying a smoothing function to the time series data, and preferably the smoothing function comprises at least one of a simple moving average function, a cumulative rolling average function, a weighted moving average function, an exponential moving average function, and an autoregressive-moving average function.

7. The method of claim 1, wherein the dispensing device applies the first amount of material according to a first value of a second operating parameter of the dispensing system, wherein the method further comprises:
adjusting a value of the second operating parameter to a second value in response to the determination that the characteristic of the amount of material, after being applied on the subsequent substrate, is estimated to be outside of the range, wherein the second amount of material is applied to the second substrate further according to the second value of the second parameter.

8. The method of claim 1, further comprising:
operating the dispensing device to apply a third amount of material to a third substrate of the sequence of substrates according to a third value of the operating parameter of the dispensing system;
measuring, using the sensor, a characteristic of the third amount of material applied on the third substrate;
determining, based on the characteristic of the third amount of material applied on the third substrate, that a characteristic of an amount of material, after being applied on a substrate subsequent to the third substrate in the sequence of substrates, is estimated to be within the range; and
applying, according to the third value of the operating parameter, a fourth amount of material from the dispensing device to a fourth substrate of the sequence of substrates,
wherein the third substrate is at least two substrates subsequent in the sequence of substrates to the second substrate.

9. The method of claim 1, further comprising:
operating the dispensing device (108) to apply a third amount of material to a third substrate of the sequence of substrates according to a third value of the operating parameter of the dispensing system;
measuring, using the sensor (62), a characteristic of the third amount of material applied on the third substrate;
determining, based on the characteristic of the third amount of material applied on the third substrate, that a characteristic of an amount of material, after being applied on a substrate subsequent to the third substrate in the sequence of substrates, is estimated to be within the range and outside of a second range;
adjusting the value of the operating parameter to a fourth value in response to the determination that the characteristic of the amount of material, after being applied on the substrate subsequent to the third substrate, is estimated to be within the range and outside of the second range; and
applying, according to the fourth value of the operating parameter, a fourth amount of material from the dispensing device to a fourth substrate of the sequence of substrates, wherein the characteristic of the third amount of material applied to the third substrate is different than a characteristic of the fourth amount of material applied to the fourth substrate.

10. The method of claim 1, wherein the first amount of material on the first substrate is cured when the characteristic of the first amount of material is measured.

11. The method of claim 1, wherein determining that the characteristic of the amount of material to be applied on the subsequent substrate is estimated to be outside of the range comprises:
determining that the characteristic of an amount of material to be applied on a second subsequent substrate in the sequence of substrates is estimated to be outside of the range.

12. A dispensing system (100) for applying a liquid or viscous material to substrates that are moved through the dispensing system, comprising:
a dispensing device (108);
a sensor (62) arranged to measure a characteristic of an amount of material applied by the dispensing device to a substrate of a sequence of substrates moved through the dispensing system; and
a controller (132) configured to generate one or more signals to:
operate the dispensing device (108) to apply a first amount of material on a first substrate (114) of the sequence of substrates according to a first value of an operating parameter of the dispensing system;
generate, using the sensor (62), information concerning a characteristic of the first amount of material applied on the first substrate (114), the information comprising a measured value of the characteristic of the first amount of material applied on the first substrate (114);
determine an estimate of a characteristic of an amount of material, after being applied on a subsequent substrate (114) in the sequence of substrates, based on the measured value of the characteristic of the first amount of material;
compare the estimate of the characteristic of the amount of material, after being applied on the subsequent substrate, with a range to determine that the estimate of the characteristic of the amount of material, after being applied on the subsequent substrate, is outside of the range;
adjust the value of the operating parameter to a second value in response to determining, with a confidence level equal to or greater than a pre-determined threshold confidence level, that the estimate of the characteristic of the amount of material, after being applied on the subsequent substrate, is outside of the range, the pre-determined threshold confidence level defining a requirement to be met for the predicted value of the characteristic of the subsequent amount of material to be considered valid; and
apply, according to the second value of the operating parameter, a second amount of material from the dispensing device to a second substrate of the sequence of substrates,
wherein the characteristic of the first amount of material applied on the first substrate is different than a characteristic of the second amount of material applied on the second substrate.

13. The dispensing system of claim 12, further comprising:
a dispensing assembly (104) comprising the dispensing device (108); and
an inspection station (130) comprising the sensor and configured to receive a substrate of the sequence of substrates after an amount of material is applied to the substrate.

14. The dispensing system of claim 13, wherein the inspection station is separate from the dispensing assembly.

15. The dispensing system of claim 13, further comprising:
a curing oven configured to cure an amount of material applied to a substrate of the sequence of substrates.

16. The dispensing system of claim 12, wherein at least one of:
the sensor (62) comprises a camera configured to capture an image of an amount of material applied to a substrate of the sequence of substrates;
the dispensing device (108) and the sensor (62) are integrated in a common assembly; or
the assembly (104) comprises a movable arm and at least one of the dispensing device (108) and
the sensor (62) is affixed to the movable arm.

17. The dispensing system of claim 12, further comprising:
a movable arm; and
a sensor assembly (316) affixed to the movable arm, wherein the sensor assembly (316) comprises the sensor (62) and an ultraviolet light source, and wherein the sensor (62) comprises a camera configured to capture an image of an amount of material applied to a substrate of the sequence of substrates.

## Patentansprüche

1. Verfahren zur Steuerung eines Dosiersystems (100), wobei das Dosiersystem von einer Steuerung (132) betrieben wird und eine Dosiervorrichtung (108) aufweist, die konfiguriert ist, ein flüssiges oder viskoses Material auf eine Abfolge von Substraten (114) aufzutragen, die durch das Dosiersystem bewegt werden, wobei das Verfahren umfasst:
Betreiben der Dosiervorrichtung (108), um eine erste Materialmenge gemäß einem ersten Wert eines Betriebsparameters des Dosiersystems auf ein erstes Substrat (114) der Abfolge von Substraten aufzutragen;
Messen, unter Verwendung eines Sensors (62), eines Wertes eines Merkmals der auf das erste Substrat (114) aufgetragenen ersten Materialmenge, um einen gemessenen Wert des Merkmals der auf das erste Substrat (114) aufgetragenen ersten Materialmenge zu erhalten;
Bestimmen, basierend auf dem gemessenen Wert des Merkmals der auf das erste Substrat (114) aufgetragenen ersten Materialmenge, dass ein vorhergesagter Wert eines Merkmals einer nachfolgenden Materialmenge, nachdem sie gemäß dem ersten Wert des Betriebsparameters des Dosiersystems auf ein nachfolgendes Substrat in der Abfolge von Substraten aufgetragen wurde, voraussichtlich außerhalb eines Bereichs liegt;
Anpassen des Wertes des Betriebsparameters auf einen zweiten Wert in Reaktion auf die Bestimmung, mit einem Konfidenzniveau, das gleich oder größer als ein vorbestimmtes Schwellen-Konfidenzniveau ist, dass der vorhergesagte Wert des Merkmals der nachfolgenden Materialmenge, die auf das nachfolgende Substrat aufgetragen werden soll, voraussichtlich außerhalb des Bereichs liegt, wobei das vorbestimmte Schwellen-Konfidenzniveau eine Anforderung definiert, die erfüllt werden muss, damit der vorhergesagte Wert des Merkmals der nachfolgenden Materialmenge als gültig angesehen wird; und
Auftragen, gemäß dem zweiten Wert des Betriebsparameters, einer zweiten Materialmenge aus der Dosiervorrichtung (108) auf ein zweites Substrat (114) der Abfolge von Substraten,
wobei das Merkmal der auf das erste Substrat aufgetragenen ersten Materialmenge sich von einem Merkmal der auf das zweite Substrat aufgetragenen zweiten Materialmenge unterscheidet.

2. Verfahren nach Anspruch 1, wobei das Merkmal der auf das erste Substrat aufgetragenen ersten Materialmenge mindestens eines von einer Position auf dem Substrat, einer Größe, einer Form und einer Dicke umfasst.

3. Verfahren nach Anspruch 1, wobei der Betriebsparameter mit mindestens einem von einem Fluiddruck des der Düse (134) der Dosiervorrichtung zugeführten Materials, einer Durchflussrate des der Düse zugeführten Materials, einer Dosierrate des Materials aus der Düse, einer Rate, mit der die Abfolge von Substraten beschichtet wird, und einem Luftdruck eines Zerstäubungsluftstrahl der Dosiervorrichtung assoziiert ist.

4. Verfahren nach Anspruch 1, wobei das Merkmal der ersten Materialmenge an einem bezeichneten nicht-funktionalen Probenbereich des ersten Substrats (114) gemessen wird, wobei der bezeichnete nicht-funktionale Probenbereich des ersten Substrats eine Zielposition umfasst und das Merkmal der ersten Materialmenge eine Position der ersten Materialmenge relativ zur Zielposition umfasst.

5. Verfahren nach Anspruch 1, wobei der zweite Wert, auf den der Betriebsparameter angepasst wird, auch basierend darauf bestimmt wird, dass das Konfidenzniveau gleich oder größer als ein Referenz-Konfidenzniveau ist.

6. Verfahren nach Anspruch 1, wobei das Anpassen des Wertes des Betriebsparameters auf den zweiten Wert auf einem oder mehreren Merkmalen von Materialmengen basiert, die auf einem oder mehreren jeweiligen Substraten aufgetragen wurden, die in der Abfolge von Substraten dem ersten Substrat vorausgehen, wobei die ein oder mehreren Merkmale der auf dem einen oder mehreren dem ersten Substrat vorausgehenden Substraten aufgetragenen Materialmengen als Zeitreihendaten dargestellt sind, und wobei das Anpassen des Wertes des Betriebsparameters auf den zweiten Wert auf den Zeitreihendaten basiert, und wobei das Anpassen des Wertes des Betriebsparameters auf den zweiten Wert das Anwenden einer Glättungsfunktion auf die Zeitreihendaten umfasst, und vorzugsweise die Glättungsfunktion mindestens eine von einer einfachen gleitenden Mittelwertfunktion, einer kumulativen gleitenden Mittelwertfunktion, einer gewichteten gleitenden Mittelwertfunktion, einer exponentiellen gleitenden Mittelwertfunktion und einer autoregressiv-gleitenden Mittelwertfunktion umfasst.

7. Verfahren nach Anspruch 1, wobei die Dosiervorrichtung die erste Materialmenge gemäß einem ersten Wert eines zweiten Betriebsparameters des Dosiersystems aufträgt, wobei das Verfahren ferner umfasst:
Anpassen eines Wertes des zweiten Betriebsparameters auf einen zweiten Wert in Reaktion auf die Bestimmung, dass das Merkmal der Materialmenge, nachdem sie auf das nachfolgende Substrat aufgetragen wurde, voraussichtlich außerhalb des Bereichs liegt, wobei die zweite Materialmenge auf das zweite Substrat ferner gemäß dem zweiten Wert des zweiten Parameters aufgetragen wird.

8. Verfahren nach Anspruch 1, ferner umfassend:
Betreiben der Dosiervorrichtung, um eine dritte Materialmenge gemäß einem dritten Wert des Betriebsparameters des Dosiersystems auf ein drittes Substrat der Abfolge von Substraten aufzutragen;
Messen, unter Verwendung des Sensors, eines Merkmals der auf das dritte Substrat aufgetragenen dritten Materialmenge;
Bestimmen, basierend auf dem Merkmal der auf das dritte Substrat aufgetragenen dritten Materialmenge, dass ein Merkmal einer Materialmenge, nachdem sie auf ein dem dritten Substrat nachfolgendes Substrat in der Abfolge von Substraten aufgetragen wurde, voraussichtlich innerhalb des Bereichs liegt; und
Auftragen, gemäß dem dritten Wert des Betriebsparameters, einer vierten Materialmenge aus der Dosiervorrichtung auf ein viertes Substrat der Abfolge von Substraten,
wobei das dritte Substrat in der Abfolge von Substraten mindestens zwei Substrate nach dem zweiten Substrat folgt.

9. Verfahren nach Anspruch 1, ferner umfassend:
Betreiben der Dosiervorrichtung (108), um eine dritte Materialmenge gemäß einem dritten Wert des Betriebsparameters des Dosiersystems auf ein drittes Substrat der Abfolge von Substraten aufzutragen;
Messen, unter Verwendung des Sensors (62), eines Merkmals der auf das dritte Substrat aufgetragenen dritten Materialmenge;
Bestimmen, basierend auf dem Merkmal der auf das dritte Substrat aufgetragenen dritten Materialmenge, dass ein Merkmal einer Materialmenge, nachdem sie auf ein dem dritten Substrat nachfolgendes Substrat in der Abfolge von Substraten aufgetragen wurde, voraussichtlich innerhalb des Bereichs und außerhalb eines zweiten Bereichs liegt;
Anpassen des Wertes des Betriebsparameters auf einen vierten Wert in Reaktion auf die Bestimmung, dass das Merkmal der Materialmenge, nachdem sie auf das dem dritten Substrat nachfolgende Substrat aufgetragen wurde, voraussichtlich innerhalb des Bereichs und außerhalb des zweiten Bereichs liegt; und
Auftragen, gemäß dem vierten Wert des Betriebsparameters, einer vierten Materialmenge aus der Dosiervorrichtung auf ein viertes Substrat der Abfolge von Substraten, wobei das Merkmal der auf das dritte Substrat aufgetragenen dritten Materialmenge sich von einem Merkmal der auf das vierte Substrat aufgetragenen vierten Materialmenge unterscheidet.

10. Verfahren nach Anspruch 1, wobei die erste Materialmenge auf dem ersten Substrat ausgehärtet ist, wenn das Merkmal der ersten Materialmenge gemessen wird.

11. Verfahren nach Anspruch 1, wobei das Bestimmen, dass das Merkmal der auf das nachfolgende Substrat aufzutragenden Materialmenge voraussichtlich außerhalb des Bereichs liegt, umfasst:
Bestimmen, dass das Merkmal einer Materialmenge, die auf ein zweites nachfolgendes Substrat in der Abfolge von Substraten aufzutragen ist, voraussichtlich außerhalb des Bereichs liegt.

12. Dosiersystem (100) zum Auftragen eines flüssigen oder viskosen Materials auf Substrate, die durch das Dosiersystem bewegt werden, umfassend:
eine Dosiervorrichtung (108);
einen Sensor (62), der angeordnet ist, ein Merkmal einer durch die Dosiervorrichtung auf ein Substrat einer durch das Dosiersystem bewegten Abfolge von Substraten aufgetragenen Materialmenge zu messen; und
eine Steuerung (132), die konfiguriert ist, ein oder mehrere Signale zu erzeugen, um:
die Dosiervorrichtung (108) zu betreiben, um eine erste Materialmenge gemäß einem ersten Wert eines Betriebsparameters des Dosiersystems auf ein erstes Substrat (114) der Abfolge von Substraten aufzutragen;
unter Verwendung des Sensors (62) Informationen über ein Merkmal der auf das erste Substrat (114) aufgetragenen ersten Materialmenge zu erzeugen, wobei die Informationen einen gemessenen Wert des Merkmals der auf das erste Substrat (114) aufgetragenen ersten Materialmenge umfassen;
eine Schätzung eines Merkmals einer Materialmenge zu bestimmen, nachdem sie auf ein nachfolgendes Substrat (114) in der Abfolge von Substraten aufgetragen wurde, basierend auf dem gemessenen Wert des Merkmals der ersten Materialmenge;
die Schätzung des Merkmals der Materialmenge, nachdem sie auf das nachfolgende Substrat aufgetragen wurde, mit einem Bereich zu vergleichen, um zu bestimmen, dass die Schätzung des Merkmals der Materialmenge, nachdem sie auf das nachfolgende Substrat aufgetragen wurde, außerhalb des Bereichs liegt;
den Wert des Betriebsparameters auf einen zweiten Wert anzupassen in Reaktion auf die Bestimmung, mit einem Konfidenzniveau, das gleich oder größer als ein vorbestimmtes Schwellen-Konfidenzniveau ist, dass die Schätzung des Merkmals der Materialmenge, nachdem sie auf das nachfolgende Substrat aufgetragen wurde, außerhalb des Bereichs liegt, wobei das vorbestimmte Schwellen-Konfidenzniveau eine Anforderung definiert, die erfüllt werden muss, damit der vorhergesagte Wert des Merkmals der nachfolgenden Materialmenge als gültig angesehen wird; und
gemäß dem zweiten Wert des Betriebsparameters eine zweite Materialmenge aus der Dosiervorrichtung auf ein zweites Substrat der Abfolge von Substraten aufzutragen, wobei das Merkmal der auf das erste Substrat aufgetragenen ersten Materialmenge sich von einem Merkmal der auf das zweite Substrat aufgetragenen zweiten Materialmenge unterscheidet.

13. Dosiersystem nach Anspruch 12, ferner umfassend:
eine Dosierungsanordnung (104), die die Dosiervorrichtung (108) umfasst; und
eine Inspektionsstation (130), die den Sensor umfasst und konfiguriert ist, ein Substrat der Abfolge von Substraten zu empfangen, nachdem eine Materialmenge auf das Substrat aufgetragen wurde.

14. Dosiersystem nach Anspruch 13, wobei die Inspektionsstation von der Dosierungsanordnung getrennt ist.

15. Dosiersystem nach Anspruch 13, ferner umfassend:
einen Aushärteofen, der konfiguriert ist, eine auf ein Substrat der Abfolge von Substraten aufgetragene Materialmenge auszuhärten.

16. Dosiersystem nach Anspruch 12, wobei mindestens eines von:
der Sensor (62) eine Kamera umfasst, die konfiguriert ist, ein Bild einer auf ein Substrat der Abfolge von Substraten aufgetragenen Materialmenge aufzunehmen;
die Dosiervorrichtung (108) und der Sensor (62) in einer gemeinsamen Anordnung integriert sind; oder
die Anordnung (104) einen beweglichen Arm umfasst und mindestens eine von der Dosiervorrichtung (108) und dem Sensor (62) an dem beweglichen Arm befestigt ist.

17. Dosiersystem nach Anspruch 12, ferner umfassend:
einen beweglichen Arm; und
eine Sensoranordnung (316), die an dem beweglichen Arm befestigt ist, wobei die Sensoranordnung (316) den Sensor (62) und eine Ultraviolett-Lichtquelle umfasst, und wobei der Sensor (62) eine Kamera umfasst, die konfiguriert ist, ein Bild einer auf ein Substrat der Abfolge von Substraten aufgetragenen Materialmenge aufzunehmen.

## Revendications

1. Procédé de commande d'un système de distribution (100), le système de distribution étant amené à fonctionner par un dispositif de commande (132) et présentant un dispositif de distribution (108) configuré pour appliquer un matériau liquide ou visqueux sur une séquence de substrats (114) qui sont déplacés à travers le système de distribution, le procédé comprenant :
le fonctionnement du dispositif de distribution (108) pour appliquer une première quantité de matériau sur un premier substrat (114) de la séquence de substrats selon une première valeur d'un paramètre de fonctionnement du système de distribution ;
la mesure, en utilisant un capteur (62), d'une valeur d'une caractéristique de la première quantité de matériau appliquée sur le premier substrat (114) pour obtenir une valeur mesurée de la caractéristique de la première quantité de matériau appliquée sur le premier substrat (114) ;
la détermination, sur la base de la valeur mesurée de la caractéristique de la première quantité de matériau appliquée sur le premier substrat (114), qu'une valeur prédite d'une caractéristique d'une quantité de matériau ultérieure, après avoir été appliquée sur un substrat ultérieur dans la séquence de substrats selon la première valeur du paramètre de fonctionnement du système de distribution, est estimée être en dehors d'une plage ;
l'ajustement de la valeur du paramètre de fonctionnement à une deuxième valeur en réponse à la détermination, avec un niveau de confiance égal ou supérieur à un niveau de confiance seuil prédéterminé, que la valeur prédite de la caractéristique de la quantité ultérieure de matériau, à appliquer sur le substrat ultérieur, est estimée être en dehors de la plage, le niveau de confiance seuil prédéterminé définissant une exigence à remplir pour que la valeur prédite de la caractéristique de la quantité de matériau ultérieure soit considérée comme étant valide ; et
l'application, selon la deuxième valeur du paramètre de fonctionnement, d'une deuxième quantité de matériau à partir du dispositif de distribution (108) sur un deuxième substrat (114) de la séquence de substrats,
dans lequel la caractéristique de la première quantité de matériau appliquée sur le premier substrat est différente d'une caractéristique de la deuxième quantité de matériau appliquée sur le deuxième substrat.

2. Procédé selon la revendication 1, dans lequel la caractéristique de la première quantité de matériau appliquée sur le premier substrat comprend au moins l'un parmi un emplacement sur le substrat, une taille, une forme et une épaisseur.

3. Procédé selon la revendication 1, dans lequel le paramètre de fonctionnement est associé à au moins l'un parmi une pression de fluide du matériau fourni à une buse (134) du dispositif de distribution, un débit du matériau fourni à la buse, une vitesse de distribution du matériau à partir de la buse, une vitesse à laquelle la séquence de substrats sont revêtus, et une pression d'air d'un jet d'air d'atomisation du dispositif de distribution.

4. Procédé selon la revendication 1, dans lequel la caractéristique de la première quantité de matériau est mesurée au niveau d'une zone d'échantillon non fonctionnelle désignée du premier substrat (114), dans lequel la zone d'échantillon non fonctionnelle désignée du premier substrat comprend un emplacement cible et la caractéristique de la première quantité de matériau comprend un emplacement de la première quantité de matériau par rapport à l'emplacement cible.

5. Procédé selon la revendication 1, dans lequel la deuxième valeur à laquelle est ajusté le paramètre de fonctionnement est également déterminée sur la base du niveau de confiance qui est égal ou supérieur à un niveau de confiance de référence.

6. Procédé selon la revendication 1, dans lequel l'ajustement de la valeur du paramètre de fonctionnement à la deuxième valeur est basé sur une ou plusieurs caractéristiques de quantités de matériau appliquées sur un ou plusieurs substrats respectifs antérieurs dans la séquence de substrats au premier substrat, dans lequel les une ou plusieurs caractéristiques des quantités de matériau appliquées sur les un ou plusieurs substrats antérieurs au premier substrat sont représentées sous forme de données de série temporelle, et dans lequel l'ajustement de la valeur du paramètre de fonctionnement à la deuxième valeur est basé sur les données de série temporelle, et dans lequel l'ajustement de la valeur du paramètre de fonctionnement à la deuxième valeur inclut l'application d'une fonction de lissage aux données de série temporelle, et préférablement, la fonction de lissage comprend au moins l'une parmi une fonction de moyenne mobile simple, une fonction de moyenne glissante cumulée, une fonction de moyenne mobile pondérée, une fonction de moyenne mobile exponentielle et une fonction de moyenne mobile auto-régressive.

7. Procédé selon la revendication 1, dans lequel le dispositif de distribution applique la première quantité de matériau selon une première valeur d'un deuxième paramètre de fonctionnement du système de distribution, dans lequel le procédé comprend en outre :
l'ajustement d'une valeur du deuxième paramètre de fonctionnement à une deuxième valeur en réponse à la détermination que la caractéristique de la quantité de matériau, après avoir été appliquée sur le substrat ultérieur, est estimée être en dehors de la plage, dans lequel la deuxième quantité de matériau est en outre appliquée sur le deuxième substrat selon la deuxième valeur du deuxième paramètre.

8. Procédé selon la revendication 1, comprenant en outre :
le fonctionnement du dispositif de distribution pour appliquer une troisième quantité de matériau sur un troisième substrat de la séquence de substrats selon une troisième valeur du paramètre de fonctionnement du système de distribution ;
la mesure, en utilisant le capteur, d'une caractéristique de la troisième quantité de matériau appliquée sur le troisième substrat ;
la détermination, sur la base de la caractéristique de la troisième quantité de matériau appliquée sur le troisième substrat, qu'une caractéristique d'une quantité de matériau, après avoir été appliquée sur un substrat ultérieur au troisième substrat dans la séquence de substrats, est estimée être dans la plage ; et
l'application, selon la troisième valeur du paramètre de fonctionnement, d'une quatrième quantité de matériau à partir du dispositif de distribution sur un quatrième substrat de la séquence de substrats,
dans lequel le troisième substrat est ultérieur d'au moins deux substrats dans la séquence de substrats par rapport au deuxième substrat.

9. Procédé selon la revendication 1, comprenant en outre :
le fonctionnement du dispositif de distribution (108) pour appliquer une troisième quantité de matériau sur un troisième substrat de la séquence de substrats selon une troisième valeur du paramètre de fonctionnement du système de distribution ;
la mesure, en utilisant le capteur (62), d'une caractéristique de la troisième quantité de matériau appliquée sur le troisième substrat ;
la détermination, sur la base de la caractéristique de la troisième quantité de matériau appliquée sur le troisième substrat, qu'une caractéristique d'une quantité de matériau, après avoir été appliquée sur un substrat ultérieur au troisième substrat dans la séquence de substrats, est estimée être dans la plage et en dehors d'une deuxième plage ;
l'ajustement de la valeur du paramètre de fonctionnement à une quatrième valeur en réponse à la détermination que la caractéristique de la quantité de matériau, après avoir été appliquée sur le substrat ultérieur au troisième substrat, est estimée être dans la plage et en dehors de la deuxième plage ; et
l'application, selon la quatrième valeur du paramètre de fonctionnement, d'une quatrième quantité de matériau à partir du dispositif de distribution sur un quatrième substrat de la séquence de substrats, dans lequel la caractéristique de la troisième quantité de matériau appliquée sur le troisième substrat est différente d'une caractéristique de la quatrième quantité de matériau appliquée sur le quatrième substrat.

10. Procédé selon la revendication 1, dans lequel la première quantité de matériau sur le premier substrat est durcie lorsque la caractéristique de la première quantité de matériau est mesurée.

11. Procédé selon la revendication 1, dans lequel la détermination que la caractéristique de la quantité de matériau à appliquer sur le substrat ultérieur est estimée être en dehors de la plage comprend :
la détermination que la caractéristique d'une quantité de matériau à appliquer sur un deuxième substrat ultérieur dans la séquence de substrats est estimée être en dehors de la plage.

12. Système de distribution (100) pour appliquer un matériau liquide ou visqueux sur des substrats qui sont déplacés à travers le système de distribution, comprenant :
un dispositif de distribution (108) ;
un capteur (62) agencé pour mesurer une caractéristique d'une quantité de matériau appliquée par le dispositif de distribution sur un substrat d'une séquence de substrats déplacés à travers le système de distribution ; et
un dispositif de commande (132) configuré pour générer un ou plusieurs signaux pour :
faire fonctionner le dispositif de distribution (108) pour appliquer une première quantité de matériau sur un premier substrat (114) de la séquence de substrats selon une première valeur d'un paramètre de fonctionnement du système de distribution ;
générer, en utilisant le capteur (62), des informations concernant une caractéristique de la première quantité de matériau appliquée sur le premier substrat (114), les informations comprenant une valeur mesurée de la caractéristique de la première quantité de matériau appliquée sur le premier substrat (114) ;
déterminer une estimation d'une caractéristique d'une quantité de matériau, après avoir été appliquée sur un substrat (114) ultérieur dans la séquence de substrats, sur la base de la valeur mesurée de la caractéristique de la première quantité de matériau ;
comparer l'estimation de la caractéristique de la quantité de matériau, après avoir été appliquée sur le substrat ultérieur, avec une plage pour déterminer que l'estimation de la caractéristique de la quantité de matériau, après avoir été appliquée sur le substrat ultérieur, est en dehors de la plage ;
ajuster la valeur du paramètre de fonctionnement à une deuxième valeur en réponse à la détermination, avec un niveau de confiance égal ou supérieur à un niveau de confiance seuil prédéterminé, que l'estimation de la caractéristique de la quantité de matériau, après avoir été appliquée sur le substrat ultérieur, est en dehors de la plage, le niveau de confiance seuil prédéterminé définissant une exigence à remplir pour que la valeur prédite de la caractéristique de la quantité de matériau ultérieure soit considérée comme étant valide ; et
appliquer, selon la deuxième valeur du paramètre de fonctionnement, une deuxième quantité de matériau à partir du dispositif de distribution sur un deuxième substrat de la séquence de substrats,
dans lequel la caractéristique de la première quantité de matériau appliquée sur le premier substrat est différente d'une caractéristique de la deuxième quantité de matériau appliquée sur le deuxième substrat.

13. Système de distribution selon la revendication 12, comprenant en outre :
un ensemble de distribution (104) comprenant le dispositif de distribution (108) ; et
une station d'inspection (130) comprenant le capteur et configurée pour recevoir un substrat de la séquence de substrats après qu'une quantité de matériau est appliquée sur le substrat.

14. Système de distribution selon la revendication 13, dans lequel la station d'inspection est séparée de l'ensemble de distribution.

15. Système de distribution selon la revendication 13, comprenant en outre :
un four de durcissement configuré pour durcir une quantité de matériau appliquée sur un substrat de la séquence de substrats.

16. Système de distribution selon la revendication 12, dans lequel au moins un parmi:
le capteur (62) comprend une caméra configurée pour capturer une image d'une quantité de matériau appliquée sur un substrat de la séquence de substrats ;
le dispositif de distribution (108) et le capteur (62) sont intégrés dans un ensemble commun ; ou l'ensemble (104) comprend un bras mobile et au moins l'un du dispositif de distribution (108) et du capteur (62) est fixé au bras mobile.

17. Système de distribution selon la revendication 12, comprenant en outre :
un bras mobile ; et
un ensemble (316) de capteur fixé au bras mobile, dans lequel l'ensemble (316) de capteur comprend le capteur (62) et une source de lumière ultraviolette, et dans lequel le capteur (62) comprend une caméra configurée pour capturer une image d'une quantité de matériau appliquée sur un substrat de la séquence de substrats.
